(19) Europäisches Patentamt
European Patent Office
Office européen des brevets

(11) **EP 4 576 259 A1**

(12) **EUROPEAN PATENT APPLICATION**
published in accordance with Art. 153(4) EPC

(43) Date of publication:
**25.06.2025   Bulletin 2025/26**

(21) Application number: **24863834.8**

(22) Date of filing: **29.09.2024**

(51) International Patent Classification (IPC):
*H01M 4/505* (2010.01)        *H01M 4/525* (2010.01)
*H01M 10/0525* (2010.01)      *C01G 53/00* (2025.01)
*C30B 29/22* (2006.01)         *C30B 1/10* (2006.01)

(52) Cooperative Patent Classification (CPC):
Y02E 60/10

(86) International application number:
**PCT/CN2024/122465**

(87) International publication number:
**WO 2025/077631 (17.04.2025 Gazette 2025/16)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **13.10.2023   CN 202311331910**

(71) Applicant: **BTR NANO TECH CO., LTD.
Shenzhen, Guangdong 518106 (CN)**

(72) Inventors:
• **LIU, Guoxue
Shenzhen
Guangdong 518106 (CN)**
• **WAN, Jiping
Shenzhen
Guangdong 518106 (CN)**

• **ZHENG, Yu
Shenzhen
Guangdong 518106 (CN)**
• **RAO, Xiangxiang
Shenzhen
Guangdong 518106 (CN)**
• **WU, Xiaozhen
Shenzhen
Guangdong 518106 (CN)**
• **YANG, Shunyi
Shenzhen
Guangdong 518106 (CN)**
• **HUANG, Youyuan
Shenzhen
Guangdong 518106 (CN)**

(74) Representative: **Winter, Brandl - Partnerschaft
mbB
Alois-Steinecker-Straße 22
85354 Freising (DE)**

(54) **POSITIVE ELECTRODE MATERIAL PRECURSOR, SINGLE CRYSTAL POSITIVE ELECTRODE MATERIAL AND PREPARATION METHOD THEREFOR, AND LITHIUM-ION BATTERY**

(57)    The present application relates to a cathode material precursor, a single-crystal cathode material and a preparation method thereof, and a lithium ion battery. A general chemical formula of the single-crystal cathode material is $Li_xNi_aCo_bMn_cN_dO_2$, where $0.98 \leq x \leq 1.1$, $0.50 \leq a \leq 0.98$, $0 < b \leq 0.20$, $0 < c \leq 0.30, 0 \leq d \leq 0.10$, $a+b+c+d=1$, and N includes at least one of Al, Ti, Zr, Mg, Sr, Ba, Ca, Nb, W, Sb, Ta, Sn, or Y; a standard deviation of a mass content of each element of Ni, Co, and Mn in the single-crystal cathode material is $\leq 0.03$; and lattice strain is $\varepsilon < 0.2\%$. According to the single-crystal cathode material provided in the present application, the lattice strain is low, diffusion energy barriers of lithium ions among crystallite can be reduced, such that a material shows low DCR and good rate performance; and generation of microcracks can also be inhibited, thereby improving the cycling performance of the material.

EP 4 576 259 A1

Fig. 4

**Description**

**Cross-Reference to Related Application**

This application claims priority to Chinese Patent Application No. "202311331910.3" filed to the China National Intellectual Property Administration on October 13, 2023 and entitled "Cathode Material Precursor, Single-crystal cathode material and Preparation Method Thereof, and Lithium Ion Battery", the disclosure of which is hereby incorporated by reference in its entirety.

**Technical Field**

The present application relates to the technical field of cathode materials, and in particular, to a cathode material precursor, a single-crystal cathode material and a preparation method thereof, and a lithium ion battery.

**Background**

Lithium ion cathode materials are mainly classified into lithium iron phosphate and ternary materials. Because the cost, cycle life, and thermal stability of the lithium iron phosphate are superior to those of the ternary material, the lithium iron phosphate is suitable for the fields such as commercial vehicles, low-to-medium end passenger cars, energy storage, etc. The ternary material is high in energy density and good in low temperature performance, and thus is suitable for mid-to-high end passenger cars.

A traditional polycrystalline ternary cathode material is composed of spherical secondary particles (with a particle size being generally >10 $\mu$m) that are formed by tightly agglomerating primary particles (hundreds of nanometers). During charging and discharging, as lattice contracts, local stress is easily generated along a grain boundary, leading to structural collapse of a material and formation of microcracks, thus causing the capacity of the cathode material to rapidly fade. Monocrystallization is a method to improve the cycling performance of the ternary material. A monocrystalline ternary material is composed of dispersed primary particles (a particle size is generally a few micrometers, and most of the particles are single crystal grains with a same orientation), and no spherical secondary particles are present. Since the grain boundary is eliminated, the cracking of the cathode material during charging and discharging can be inhibited, showing excellent stability. However, the monocrystalline ternary material also faces other problems. A diffusion path of the monocrystalline ternary material Li is long, causing slow transmission power of the Li, and performance is characterized by large Direct Current Resistance (DCR) and poor rate performance. In addition, although the monocrystalline particles can inhibit particle cracking, phenomena such as planar gridding, misalignment, etc. still occur in a cycle process, further causing microcracks.

The ternary single-crystal cathode material is generally prepared by sintering a precursor compound containing Ni/Co/Mn and a lithium salt at a high temperature. During sintering, the cathode material is generally formed at a very slow speed, and has an uneven growth rate, resulting in concentrated stress inside the formed cathode material. In addition, limited by ion diffusion, there is a concentration difference in the distribution of elements in the ternary material, causing internal lattice parameters of the material to be unmatched. On the one hand, the transmission of lithium ions is hindered, such that the impedance of the cathode material is increased, and the rate performance of the cathode material is reduced; and on the other hand, internal lattice microstress cracks and pulverizes the cathode material in the cycle process, thus reducing the cycling performance of the cathode material.

Therefore, how to improve the rate performance of a single-crystal cathode material, reduce impedance, and further improve cycling performance is still a technical problem to be solved currently.

**Summary**

The present application is intended to provide a cathode material precursor, a single-crystal cathode material and a preparation method thereof, and a lithium ion battery. According to the single-crystal cathode material provided in the present application, the lattice strain is low, diffusion energy barriers of lithium ions among crystallite can be reduced, and Li ion diffusion coefficients are increased, such that the single-crystal cathode material shows low DCR, and a good rate performance of the single-crystal cathode material; and phenomena such as planar gridding, misalignment, etc. may also be reduced to inhibit the generation of microcracks, so as to improve the structural stability of the single-crystal cathode material, thereby improving the cycling performance of the single-crystal cathode material.

In a first aspect, an embodiment of the present application provides a single-crystal cathode material. A general chemical formula of the single-crystal cathode material is $Li_xNi_aCo_bMn_cN_dO_2$, where $0.98 \leq x \leq 1.1$, $0.50 \leq a \leq 0.98$, $0 < b \leq 0.20$, $0 < c \leq 0.30$, $0 \leq d \leq 0.10$, $a+b+c+d=1$, and N includes at least one of Al, Ti, Zr, Mg, Sr, Ba, Ca, Nb, W, Sb, Ta, Sn, or Y.

When the single crystal cathode materials are observed by Scanning Electron Microscope (SEM) at a magnification of 3K, 10 points are randomly selected to perform an Energy Dispersive Spectrometer (EDS) point scanning to test contents of Ni, Co, and Mn, and in EDS spectrum results of the single-crystal cathode material, a standard deviation of a mass content of each element of Ni, Co, and Mn in the single-crystal cathode material is ≤0.03.

Lattice strain of the single-crystal cathode material is $\varepsilon$, and $\varepsilon < 0.2\%$.

In some implementations, the single-crystal cathode material includes $SO_4^{2-}$. A content of the $SO_4^{2-}$ is $\delta$, and 0 ppm≤$\delta$≤800 ppm.

In some implementations, the single-crystal cathode material contains at least one single crystal grain with a same orientation, and an average particle size of the single crystal grains is 1 $\mu$m-5 $\mu$m.

In some implementations, a grain size of the single-crystal cathode material is D, and 150 nm < D < 250 nm.

In some implementations, an average particle size $D_{50}$ of the single-crystal cathode material is 1.5 $\mu$m-5 $\mu$m.

In some implementations, a tap density of the single-crystal cathode material is >1.5 g/cm$^3$.

In some implementations, a range of the mass content of each element of the Ni, Co, and Mn in the single-crystal cathode material is ≤0.08.

In a second aspect, an embodiment of the present application provides a cathode material precursor. A general chemical formula of the cathode material precursor is $Ni_aCo_bMn_cN_dO_e$, where 0.50≤a≤0.98, 0 < b≤0.20, 0 < c≤0.30, 0≤d≤0.10, a+b+c+d=1, 1≤e≤1.15, and N includes at least one of Al, Ti, Zr, Mg, Sr, Ba, Ca, Nb, W, Sb, Ta, Sn, or Y.

A surface area weighted average particle size of the cathode material precursor is D[3, 2] < 2.0 $\mu$m, and a standard deviation of a mass content of each element of Ni, Co, and Mn in the cathode material precursor is ≤0.05.

In some implementations, a range of the mass content of each element of the Ni, Co, and Mn in the cathode material precursor is ≤0.12.

In some implementations, the cathode material precursor includes a secondary particle, and the secondary particle includes a plurality of agglomerated primary particles.

In some implementations, the cathode material precursor includes the secondary particle, the secondary particle includes the plurality of agglomerated primary particles, and the primary particles are spherical in shape.

In some implementations, the cathode material precursor includes the secondary particle, the secondary particle includes the plurality of agglomerated primary particles, and a particle size of the primary particle is 20 nm-1000 nm.

In some implementations, an average particle size $D_{50}$ of the cathode material precursor is <3.5 $\mu$m.

In some implementations, a specific surface area of the cathode material precursor is >5 m$^2$/g.

In some implementations, a tap density of the cathode material precursor is >1 g/cm$^3$.

In a third aspect, an embodiment of the present application provides a method for preparing a single-crystal cathode material, including the following steps.

Atomization treatment is performed on a mixed solution containing a nickel salt, a cobalt salt, and a manganese salt, and then thermal decomposition is performed to obtain a cathode material precursor, where a surface area weighted average particle size of the cathode material precursor is D[3, 2] < 2.0 $\mu$m, and a standard deviation of a mass content of each element of Ni, Co, and Mn in the cathode material precursor is ≤0.05; and the cathode material precursor and a lithium source are mixed, and then placed under an oxygen-containing atmosphere for sintering, so as to obtain a single-crystal cathode material, where a standard deviation of a mass content of each element of Ni, Co, and Mn in the single-crystal cathode material is ≤0.03; and lattice strain of the single-crystal cathode material is $\varepsilon$, and $\varepsilon < 0.2\%$.

In some implementations, the cathode material precursor includes $SO_4^{2-}$. A content of the $SO_4^{2-}$ is $\eta$, and 0 ppm≤$\eta$≤1800 ppm.

In some implementations, the nickel salt includes at least one of nickel chloride, nickel sulfate, nickel nitrate, nickel carbonate, nickel oxalate, or nickel acetate.

In some implementations, the cobalt salt includes at least one of cobalt chloride, cobalt oxalate, cobalt carbonate, cobalt sulfate, cobalt nitrate, or cobalt acetate.

In some implementations, the manganese salt includes at least one of manganese chloride, manganese carbonate, manganese sulfate, manganese oxalate, manganese nitrate, or manganese acetate.

In some implementations, a molar ratio of Ni, Co, to Mn in the mixed solution is (50-98):(0-20):(0-30), and the contents of the Co and Mn in the mixed solution are not 0.

In some implementations, a total metal concentration in the mixed solution is 200 g/L-500 g/L.

In some implementations, the mixed solution further includes a doping agent containing an N element, and N includes at least one of Al, Ti, Zr, Mg, Sr, Ba, Ca, Nb, W, Sb, Ta, Sn, or Y.

In some implementations, a general chemical formula of the cathode material precursor is $Ni_aCo_bMn_cN_dO_e$, where 0.50≤a≤0.98, 0 < b≤0.20, 0 < c≤0.30, 0≤d≤0.10, a+b+c+d=1, 1≤e≤1.15, and N includes at least one of Al, Ti, Zr, Mg, Sr, Ba, Ca, Nb, W, Sb, Ta, Sn, or Y.

In some implementations, a range of the mass content of each element of the Ni, Co, and Mn in the cathode material precursor is ≤0.12.

In some implementations, a flow rate of the mixed solution is 100 L/h-900 L/h.

In some implementations, pressure for atomization treatment is 0.4 MPa-0.8 MPa.

In some implementations, a temperature for first sintering is 500 °C-850 °C.

In some implementations, the lithium source includes at least one of lithium carbonate, lithium hydroxide, lithium acetate, lithium sulfate, lithium chloride, lithium nitrate, or lithium oxalate.

In some implementations, a molar ratio of lithium in the lithium source to the sum of nickel, cobalt, and manganese in the cathode material precursor is 0.98-1.10.

In some implementations, a sintering temperature is 750 °C-950 °C.

In some implementations, a sintering time is 10 h-30 h.

In a fourth aspect, an embodiment of the present application provides a lithium ion battery. The lithium ion battery includes the single-crystal cathode material described in the first aspect or a single-crystal cathode material prepared by the method for preparing a single-crystal cathode material described in the third aspect.

Compared with the related art, the technical solution of the present application has at least the following beneficial effects.

In the single-crystal cathode material provided in the present application, 10 points are randomly selected for the single-crystal cathode material to perform the EDS point scanning to test the contents of Ni, Co, and Mn, and in the EDS spectrum results of the single-crystal cathode material, and the standard deviation of the mass content of each element of the Ni, Co, and Mn in the single-crystal cathode material is ≤0.03, indicating that distribution uniformity of Ni, Co, and Mn elements in the single-crystal cathode material is good, thereby facilitating reduction of defects of a crystal structure of the single-crystal cathode material. The lattice strain of the single-crystal cathode material is ε < 0.2%, such that diffusion energy barriers of lithium ions among crystallite can be reduced, and Li ion diffusion coefficients are increased, thereby causing the single-crystal cathode material to show good rate performance and low DCR. Meanwhile, the generation of the microcracks in the single-crystal cathode material may also be inhibited by reducing lattice strain, thereby improving the cycling performance of the single-crystal cathode material.

In the cathode material precursor provided in the present application, the surface area weighted average particle size of the cathode material precursor is D[3, 2] < 2.0 μm, such that reaction activity is high, and reaction efficiency and mass transfer efficiency of the cathode material precursor in the subsequent process of preparing the cathode material are improved. Meanwhile, the standard deviation of the mass content of each element of Ni, Co, and Mn in the cathode material precursor obtained by the preparation method is ≤0.05, indicating that distribution uniformity of Ni, Co, and Mn elements in the cathode material precursor is good. By using the cathode material precursor to prepare the cathode material, the distribution uniformity of the Ni, Co, and Mn elements in the cathode material may be improved, causing the cathode material prepared by the cathode material precursor to be less in defects of the crystal structure, and less in lattice stress.

According to the method for preparing a single-crystal cathode material provided in the present application, atomization treatment is performed on the mixed solution containing the nickel salt, the cobalt salt, and the manganese salt, and then thermal decomposition is performed to obtain the cathode material precursor. The surface area weighted average particle size of the cathode material precursor is D[3, 2] < 2.0 μm, such that reaction activity is high, and the reaction activity is high, and reaction efficiency and mass transfer efficiency of the cathode material precursor in the subsequent high-temperature sintering process with the lithium source are improved. Meanwhile, the standard deviation of the mass content of each element of Ni, Co, and Mn in the cathode material precursor obtained by the preparation method is ≤0.05, indicating that distribution uniformity of the Ni, Co, and Mn in the cathode material precursor is good. Then, the standard deviation of the mass content of each element of the Ni, Co, and Mn in the single-crystal cathode material prepared by subsequently sinterining the cathode material precursor and the lithium source is ≤0.03, the distribution uniformity of Ni, Co, and Mn elements in the single-crystal cathode material is good, thereby facilitating reduction of the defects of the crystal structure of the single-crystal cathode material. The lattice strain of the single-crystal cathode material is reduced, and the lattice strain is ε < 0.2%, such that diffusion energy barriers of lithium ions among crystallite can be reduced, and Li ion diffusion coefficients are increased, thereby causing the single-crystal cathode material to show good rate performance and low DCR. Meanwhile, the generation of the microcracks in the single-crystal cathode material may also be inhibited by reducing lattice strain, thereby improving the cycling performance of the single-crystal cathode material.

**Brief Description of the Drawings**

The present application is further described below with reference to the drawings and embodiments.

Fig. 1 is an SEM topography of a cathode material precursor prepared according to Embodiment 1 of the present application.

Fig. 2 is another SEM topography of a cathode material precursor prepared according to Embodiment 1 of the present application.

Fig. 3 is an EDS spectrum result of a cathode material precursor prepared according to Embodiment 1 of the present application.

Fig. 4 is a Williamsone-Hall analysis fitting curve of a single-crystal cathode material prepared according to Embodiment 1 of the present application.

## Detailed Description of the Embodiments

In order to better understand the technical solutions of the present application, embodiments of the present application are described in detail below with reference to the drawings.

It is to be clear that the described embodiments are only part of the embodiments of the present application, not all the embodiments. All other embodiments obtained by those of ordinary skill in the art on the basis of the embodiments in the present application without creative work fall within the scope of protection of the present application.

The terms used in the embodiments of the present application are only for describing specific embodiments and are not intended to limit the present application. Singular forms "a/an", "the", and "said" used in the embodiments and appended claims of the present application are also intended to include plural forms unless other meanings are clearly expressed in the context.

It is to be understood that, the term "and/or" used here is merely an association relationship describing related objects, which means that there may be three relationships, for example, A and/or B may indicate three cases: A exists alone, A and B exist simultaneously, and B exists alone. In addition, the character "/" as used herein generally indicates an "or" relationship between the front and back associated objects.

In a first aspect, an embodiment of the present application provides a single-crystal cathode material. A general chemical formula of the single-crystal cathode material is $Li_xNi_aCo_bMn_cN_dO_2$, where $0.98 \leq x \leq 1.1$, $0.50 \leq a \leq 0.98$, $0 < b \leq 0.20$, $0 < c \leq 0.30$, $0 \leq d \leq 0.10$, $a+b+c+d=1$, and N includes at least one of Al, Ti, Zr, Mg, Sr, Ba, Ca, Nb, W, Sb, Ta, Sn, or Y.

When an SEM is used to observe the single-crystal cathode material, at a magnification of 3K, 10 points are randomly selected for the single-crystal cathode material to perform an Energy Dispersive Spectrometer (EDS) point scanning so as to test contents of Ni, Co, and Mn, and in EDS spectrum results of the single-crystal cathode material, a standard deviation of a mass content of each element of Ni, Co, and Mn in the single-crystal cathode material is $\leq 0.03$.

Lattice strain of the single-crystal cathode material is $\varepsilon$, and $\varepsilon < 0.2\%$.

In the single-crystal cathode material provided in the present application, 10 points are randomly selected for the single-crystal cathode material to perform the EDS point scanning so as to test the contents of Ni, Co, and Mn, and in the EDS spectrum results of the single-crystal cathode material, and the standard deviation of the mass content of each element of the Ni, Co, and Mn in the single-crystal cathode material is $\leq 0.03$, indicating that the distribution of Ni, Co, and Mn elements in the single-crystal cathode material is relatively uniformity, thereby facilitating reduction of defects of a crystal structure of the single-crystal cathode material. The lattice strain of the single-crystal cathode material is $\varepsilon < 0.2\%$, such that diffusion energy barriers of lithium ions among crystallite can be reduced, and Li ion diffusion coefficients are increased, thereby causing the single-crystal cathode material to show high rate performance and low DCR. Meanwhile, the generation of the microcracks in the single-crystal cathode material may also be inhibited by reducing lattice strain, thereby improving the cycling performance of the single-crystal cathode material.

In particular, a value of "x" may be 0.98, 0.99, 1.0, 1.01, 1.03, 1.05, 1.08, 1.09, 1.1, or the like, and is not limited herein.

A value of "a" may specifically be 0.50, 0.55, 0.60, 0.63, 0.70, 0.75, 0.80, 0.85, 0.88, 0.90, 0.95, 0.98, or the like; a value of "b" may be 0.01, 0.05, 0.08, 0.10, 0.11, 0.13, 0.15, 0.18, 0.20, or the like; a value of "c" may be 0.01, 0.05, 0.10, 0.15, 0.18, 0.20, 0.23, 0.27, 0.30, or the like; and a value of "d" may be 0, 0.01, 0.03, 0.05, 0.06, 0.07, 0.08, 0.09, 0.10, or the like, and is not limited herein.

In particular, a standard deviation of a mass content of each element of Ni, Co, and Mn in the single-crystal cathode material may be 0.01, 0.015, 0.02, 0.025, 0.026, 0.028, 0.03, or the like, and is not limited herein.

In some implementations, a range of the mass content of each element of the Ni, Co, and Mn in the single-crystal cathode material is $\leq 0.08$, which may specifically be 0.01, 0.02, 0.028, 0.03, 0.05, 0.057, 0.06, 0.07, 0.075, 0.08, or the like, or, definitely, may also be other values within the above range, and is not limited herein.

It may be understood that, if the standard deviation and the range of the mass content of each element of Ni, Co, and Mn in the single-crystal cathode material are lower, a degree of distribution uniformity of the Ni, Co, and Mn elements in the single-crystal cathode material is higher. The standard deviation and the range of the mass content of each element of Ni, Co, and Mn in the single-crystal cathode material are within the above range, it indicates that the Ni, Co, and Mn elements in the single-crystal cathode material of the present application are uniformly distributed, such that lattice defects of the single-crystal cathode material are reduced, lattice stress is reduced, and the cycling performance and rate performance of the single-crystal cathode material are improved.

The lattice strain of the single-crystal cathode material may specifically be 0.01%, 0.03%, 0.05%, 0.08%, 0.10%, 0.11%, 0.12%, 0.15%, 0.18%, 0.19%, or the like, and is not limited herein.

In some implementations, the single-crystal cathode material further includes a coating layer. The coating layer includes a metal oxide or a lithium ion conductor; and a metal in the metal oxide comprises at least one of Al, Ti, Zr, Y, Nb, Mg, W, B, Ce, Co, or Mn. The coating layer may reduce a direct contact between the single-crystal cathode material and electrolyte, so as to reduce the occurrence of side reactions between the material and the electrolyte, thereby further improving the electrochemical performance of the single-crystal cathode material.

In some implementations, the content of free $SO_4^{2-}$ on a surface of the single-crystal cathode material is smaller than or equal to 1000 ppm, preferably, ≤800 ppm. The content of $SO_4^{2-}$ of the single-crystal cathode material may specifically be 0 ppm, 5 ppm, 10 ppm, 50 ppm, 100 ppm, 200 ppm, 300 ppm, 400 ppm, 500 ppm, 600 ppm, 700 ppm, 800 ppm, 900 ppm, 1000 ppm, or the like. When the content of the free $SO_4^{2-}$ is within the above range, the cathode material has better rate performance and cycling performance. Since a traditional ternary precursor material uses $NiSO_4$, $CoSO_4$, and $MnSO_4$ as raw materials during preparation, the co-precipitated precursor retains higher levels of sulfate ions. The sulfate ions are difficult to decompose, and thus, the content of the sulfate ions on a surface of the corresponding cathode material formed through subsequent sintering is relatively high (generally, > 1000 ppm). The free sulfate ions cause adverse effects on the electrochemical performance of the cathode material. When the content of the free $SO_4^{2-}$ on the surface is high, the $SO_4^{2-}$ binds to Li ions, and part of the Li ions are bounded, causing deterioration of the capacity and rate of the material. In addition, the free $SO_4^{2-}$ on the surface also affects the stability of a Solid Electrolyte Interface (SEI) membrane.

The content of the free $SO_4^{2-}$ on the surface of the single-crystal cathode material and the content of the free $SO_4^{2-}$ on the surface of the cathode material precursor have a strong inheritance, such that if the content of the $SO_4^{2-}$ in the cathode material precursor is higher, the content of the free $SO_4^{2-}$ on the surface of the single-crystal cathode material is higher. The content of the free $SO_4^{2-}$ on the surface of the cathode material precursor provided in the present application is ≤1000 ppm, more facilitating preparation of a cathode material in which the content of the free $SO_4^{2-}$ on the surface is ≤800 ppm.

In order to reduce the content of the $SO_4^{2-}$ in the single-crystal cathode material precursor, in some embodiments, a Ni salt, a Mn salt, a Co salt, and a N salt each independently include at least one of a chloride salt, nitrate salt, oxalate salt, or acetate salt. The nitrate salt, chloride salt, oxalate salt, and acetate salt of nickel, cobalt, or manganese decompose very easily at high temperatures without significant residues, and thus basically have not impact on the performance of the cathode material. By controlling the content of the $SO_4^{2-}$ in the metal salt mixed solution, even the cathode material precursor in which the content of the $SO_4^{2-}$ is close to 0 may be prepared. However, this has a high requirement for the purity of a raw material, resulting in an increase in the cost of the raw material. A Ni source, a Co source, a Mn source, and a N source in a ternary recycled material containing $SO_4^{2-}$ impurities are used as metal sources, and it is more economic to prepare the cathode material precursor by controlling the content of the $SO_4^{2-}$ in the metal sources.

In some embodiments, in the metal salt mixed solution, based on the total mass of the Ni element, Co element, and Mn element, the content of the $SO_4^{2-}$ is ≤800 ppm, facilitating preparation of the single-crystal cathode material with low content of the free $SO_4^{2-}$ on the surface, thereby further improving the capacity and rate performance of the single-crystal cathode material.

In some implementations, the single-crystal cathode material contains at least one single crystal grain with a same orientation, and an average particle size of the single crystal grains is 1 μm-5 μm, for example, 1 μm, 2 μm, 3 μm, 4 μm, 5 μm, or the like.

The monocrystalline particles of the cathode material of the present application are particles that contain at least one single crystal grain with the same orientation, and the average particle size of the single crystal grains meeting the above conditions and measured and read under an EBSD test is 1-5 um. The particles can stably achieve high filling of itself, and can also prevent the occurrence of cracks in the particles due to extrusion, etc. after the particles reach closest packing of themselves. The particles have the same orientation, thus can relieve stress strain of cathode particles during a charge-discharge cycling process, so as to greatly reduce the cracking of the particles during cycling, thereby greatly improving the structural stability of the cathode particles.

It is to be noted that, the grain orientation of the cathode material may be at least tested through Electron Back Scatter Diffraction (EBSD), and 100 single crystal grains with the same orientation are randomly selected to measure the particle size of each grain, and an arithmetic mean is taken as the average particle size of the single crystal grains.

A difference between the single-crystal cathode material and a polycrystalline ternary cathode material (i.e., polycrystalline secondary particles) lies in that, the smallest particle in the polycrystalline secondary particles is a secondary particle formed by agglomerating primary particles. For the single-crystal cathode material, the smallest particle is generally a micron-sized single primary particle. Generally, in addition to the EBSD testing means, whether a cathode product is a monocrystalline material may also be determined through characterization methods such as an SEM, a Transmission Electron Microscope (TEM), X-Ray Diffraction (XRD), etc. For the conventional single-crystal cathode material, the SEM is also an important and reliable characterization method. The monocrystalline particle generally shows regular or irregular polyhedral appearance without significant particle agglomeration. The TEM is the second auxiliary characterization method, which is to observe whether crystal face orientations of obtained products are consistent, and perform further characterization in combination with Selected Area Electron Diffraction (SAED). The above methods may be all used to determine whether it is the single-crystal cathode material. For ease of understanding, the single-crystal cathode material of the present application may be understood as the cathode particles that contain at least one single crystal grain with the same orientation and the average particle size of the single crystal grain is 1 $\mu$m-5 $\mu$m.

It may be understood that, the single crystal grain in the present application may be a single particle formed by one primary particle. The single-crystal cathode material may also have a small number of "secondary-like particles" formed by adhering several single particles. The "primary particle" refers to a minimum particle unit that is recognized when a cathode active material is observed by the SEM; and the "secondary particle" refers to a secondary structure that is formed by agglomerating a plurality of primary particles, and shows a more rounded, spherical shape. The "secondary-like particle" is formed by adhering several single particles. Generally, the particle size of the single particle in the secondary-like particles is generally between 1 um and 5 um; and generally, a degree of particle roundness of the "secondary-like particle" is lower than that of the conventional "secondary particle".

It is to be specifically noted that, the "single-crystal cathode material" known to those skilled in the art is not "monocrystalline" in the strict sense. Crystallographically, ideal monocrystalline refers to a crystal that has exactly the same arrangement and orientation. However, limited by impurities, strain, and crystal defects, the ideal monocrystalline is very rare, and very difficult to produce in a laboratory. Therefore, single-crystal cathode materials known in the art are actually more "monocrystalline-like" cathode materials, which only show large monocrystalline-like particle sizes, as opposed to polycrystals that are formed by a large number of small primary particles.

In some implementations, a grain size of the single-crystal cathode material is D, and 150 nm < D < 250 nm. The grain size of the single-crystal cathode material may specifically be 151 nm, 155 nm, 160 nm, 170 nm, 185 nm, 190 nm, 200 nm, 205 nm, 230 nm, 245 nm, or the like, and is not limited herein. If the grain size of the single-crystal cathode material is less than 150 nm, the cycling stability of the single-crystal cathode material is relatively poor; and if the grain size of the single-crystal cathode material is greater than 250 nm, the capacity and rate performance of the single-crystal cathode material are relatively poor. By controlling the grain size of the single-crystal cathode material within the above range, the electrochemical performance of the single-crystal cathode material is improved.

It is to be noted that, the grain size generally calculated by using a half peak width through a Scherrer formula. The method has a prerequisite assumption that the lattice stress is 0, and the broadening of a diffraction peak is entirely due to the grain size. However, in fact, the lattice stress inside the single-crystal cathode material is unable to be completely ignored, and many factors cause stress concentrations inside the single-crystal cathode material, such that the grain size calculated using the Scherrer formula has its inherent limitations. In the present application, through a Williamsone-Hall method, the broadening of the diffraction peak caused by crystallite sizes and the broadening of the diffraction peak caused by the lattice stress are separated, such that the grain size calculated can better reflect the electrochemical performance of the material.

In some implementations, the average particle size $D_{50}$ of the single-crystal cathode material is 1.5 $\mu$m-5 $\mu$m, which may specifically be 1.5 $\mu$m, 1.8 $\mu$m, 2 $\mu$m, 2.5 $\mu$m, 3 $\mu$m, 3.5 $\mu$m, 4 $\mu$m, 4.5 $\mu$m, 5 $\mu$m, or the like, or may definitely be other values within the above range, and is not limited herein. By controlling the particle size of the single-crystal cathode material within the above range, the structural stability, thermal stability, and long cycling stability of the single-crystal cathode material are improved.

In some implementations, a tap density of the single-crystal cathode material is >1.5g/cm$^3$, which may specifically be 1.55 g/cm$^3$, 1.58 g/cm$^3$, 1.62 g/cm$^3$, 1.63 g/cm$^3$, 1.65 g/cm$^3$, 1.70 g/cm$^3$, 1.75 g/cm$^3$, or may definitely be other values within the above range, and is not limited herein. By controlling the tap density of the single-crystal cathode material within the above range, the energy density of a battery prepared by the single-crystal cathode material is increased.

In some implementations, a compaction density of the single-crystal cathode material is >3.0g/cm$^3$, which may specifically be 3.1 g/cm$^3$, 3.2 g/cm$^3$, 3.3 g/cm$^3$, 3.5 g/cm$^3$, 3.7 g/cm$^3$, 3.9 g/cm$^3$, 4.1 g/cm$^3$, or may definitely be other values within the above range, and is not limited herein.

In a second aspect, an embodiment of the present application provides a cathode material precursor. A general chemical formula of the cathode material precursor is $Ni_aCo_bMn_cN_dO_e$, where $0.50 \leq a \leq 0.98$, $0 < b \leq 0.20$, $0 < c \leq 0.30$, $0 \leq d \leq 0.10$, $a+b+c+d=1$, $1 \leq e \leq 1.15$, and N includes at least one of Al, Ti, Zr, Mg, Sr, Ba, Ca, Nb, W, Sb, Ta, Sn, or Y.

A surface area weighted average particle size of the cathode material precursor is D[3, 2] < 2.0 $\mu$m, and a standard deviation of a mass content of each element of Ni, Co, and Mn in the cathode material precursor is $\leq 0.05$.

In prior art, in a reaction process of the cathode material precursor and the lithium salt, limited by an ion diffusion rate and a temperature gradient, there are differences in crystal growth rates of microdomains in the material and differences in cell parameters, leading to lattice stress accumulated in the material; and the lattice stress increases diffusion energy barriers of Li ions between crystal faces/grain boundaries, reducing Li ion diffusion coefficients, and thus finally increasing the DCR of the material. The shape and structure characteristics of the cathode material precursor have a good inheritance for the cathode material, such that the composition and structure of the cathode material precursor have a direct impact on the performance of a final cathode material. In the cathode material precursor provided in the present application, the surface area weighted average particle size of the cathode material precursor is D[3, 2] < 2.0 $\mu$m, such that reaction activity is high, and reaction efficiency and mass transfer efficiency of the cathode material precursor in the subsequent process of preparing the cathode material are improved. Meanwhile, the standard deviation of the mass content of each element of Ni, Co, and Mn in the cathode material precursor obtained by the preparation method is ≤0.05, indicating that distribution uniformity of Ni, Co, and Mn elements in the cathode material precursor is good. By using the cathode material precursor to prepare the cathode material, the distribution uniformity of the Ni, Co, and Mn elements in the cathode material may be improved, causing the cathode material prepared by the cathode material precursor to be less in defects of the crystal structure, and less in lattice stress.

In some implementations, the cathode material precursor includes $SO_4^{2-}$. A content of the $SO_4^{2-}$ is $\eta$, and 0 ppm≤$\eta$≤1800 ppm.

It may be understood that, the $SO_4^{2-}$ on the surface of the cathode material precursor is difficult to decompose, and is also difficult to dope into the cathode material, such that the content of the free $SO_4^{2-}$ on the surface of the cathode material and the content of the free $SO_4^{2-}$ in the cathode material precursor may have a certain inheritance, and if the content of the $SO_4^{2-}$ in the cathode material precursor is higher, the content of the free $SO_4^{2-}$ on the surface of the cathode material is higher. The content of the free $SO_4^{2-}$ on the surface of the cathode material precursor provided in the present application is ≤1800 ppm, more facilitating preparation of a cathode material in which the content of the free $SO_4^{2-}$ on the surface is ≤800 ppm. In order to reduce the content of the $SO_4^{2-}$ in cathode material precursor, in some embodiments, a Ni salt, a Mn salt, a Co salt, and a N salt each independently include at least one of a chloride salt, nitrate salt, oxalate salt, or acetate salt. The use of nickel sulfate, cobalt sulfate, and manganese sulfate is avoided. The nitrate salt, chloride salt, oxalate salt, and acetate salt of nickel, cobalt, and manganese decompose very easily at high temperatures without significant anionic residues, and thus basically have not impact on the performance of the cathode material. By controlling the content of the $SO_4^{2-}$ in the metal salt mixed solution, even the cathode material precursor in which the content of the $SO_4^{2-}$ is close to 0 may be prepared. However, this has a high requirement for the purity of a raw material, resulting in an increase in the cost of the raw material. A Ni source, a Co source, a Mn source, and a N source in a ternary recycled material containing $SO_4^{2-}$ impurities are used as metal sources, and it is more economic to prepare the cathode material precursor by controlling the content of the $SO_4^{2-}$ in the metal sources.

In some embodiments, in the metal salt mixed solution, based on the total mass of the Ni element, Co element, and Mn element, the content of the $SO_4^{2-}$ is ≤1800 ppm, which may specifically be 500 pp, 800 ppm, 1200 ppm, 1600 ppm, 1700 ppm, 1800 ppm, or the like, and is not limited herein.

Industrially, the average particle size $D_{50}$ is generally used to represent the particle size of the cathode material precursor. However, the reaction of the cathode material precursor and the lithium salt is a process related to contact areas, such that a Sauter average particle size, which is the surface area weighted average particle size D[3, 2], is actually more suitable for representing of the particle size of the cathode material precursor. If the D[3, 2] is greater, the surface activity of the cathode material precursor is smaller, and a reaction rate with the lithium salt is slower.

It is to be noted that, the surface area weighted average particle size D[3, 2] of the cathode material precursor in the present application may be directly measured by a Malvern 3000 laser particle analyzer, which may specifically calculated through the following formula: D[3, 2] = $(\Sigma y^3 N_d)/(\Sigma y^2 N_d)$, where y is the particle size, and Nd is the number of particles with the particle size being y.

In particular, the surface area weighted average particle size D[3, 2] of the cathode material precursor may be 1.98 $\mu$m, 1.95 $\mu$m, 1.8 $\mu$m, 1.75 $\mu$m, 1.64 $\mu$m, 1.5 $\mu$m, 1.3 $\mu$m, 1.2 $\mu$m, 1.1 $\mu$m, 0.8 $\mu$m, 0.9 $\mu$m, 0.5 $\mu$m, and is not limited herein. By controlling the surface area weighted average particle size D[3, 2] of the cathode material precursor within the above range, the reaction activity of the cathode material precursor is high, facilitating improvement of the reaction efficiency and mass transfer efficiency of the cathode material precursor in the subsequent sinterining process with the lithium source.

The standard deviation of the mass content of each element of Ni, Co, and Mn in the cathode material precursor may specifically be 0.001, 0.005, 0.009, 0.01, 0.013, 0.02, 0.025, 0.03, 0.036, 0.04, 0.044, 0.045, 0.047, 0.049, or the like, and is not limited herein.

In some implementations, the range of the mass content of each element of the Ni, Co, and Mn in the cathode material precursor is ≤0.12, which may specifically be 0.01, 0.015, 0.018, 0.02, 0.029, 0.03, 0.035, 0.048, 0.059, 0.06, 0.08, 0.097, 0.10, 0.105, 0.11, 0.112, 0.115, 0.119, or the like, or, definitely, may also be other values within the above range, and is not limited herein.

It may be understood that, the standard deviation and range of the mass content of each element of Ni, Co, and Mn in the cathode material may reflect a degree of distribution uniformity of the Ni, Co, and Mn elements in the cathode material precursor. If the standard deviation and range of the mass content of each element of Ni, Co, and Mn are lower, the distribution of the Ni, Co, and Mn elements in the cathode material precursor is more uniform. Meanwhile, the distribution uniformity of the Ni, Co, and Mn elements in the cathode material precursor and the distribution uniformity of the Ni, Co, and Mn elements in the single-crystal cathode material have a good inheritance. If the distribution of the Ni, Co, and Mn elements in the cathode material precursor is more uniform, the distribution of the Ni, Co, and Mn elements in the single-crystal cathode material prepared by the cathode material precursor is also more uniform.

Therefore, by controlling the standard deviation and range of the mass content of each element of Ni, Co, and Mn in the cathode material precursor within the above range, the distribution uniformity of the Ni, Co, and Mn elements in the single-crystal cathode material is improved to cause the distribution uniformity of the Ni, Co, and Mn elements in the single-crystal cathode material to be good, such that the single-crystal cathode material is less in defects of the crystal structure, and less in lattice strain.

In some implementations, the cathode material precursor includes a secondary particle, and the secondary particle includes a plurality of agglomerated primary particles.

In some implementations, the cathode material precursor includes the secondary particle, the secondary particle includes the plurality of agglomerated primary particles, and the primary particles are spherical in shape.

In some implementations, the cathode material precursor includes the secondary particle, and the secondary particle includes the plurality of agglomerated primary particles. A particle size of the primary particle is 20 nm-1000 nm, which may specifically be 20 nm, 50 nm, 80 nm, 100 nm, 150 nm, 200 nm, 500 nm, 800 nm, 1000 nm, or the like, but is not limited to enumerated values, and other values not enumerated within the value range are equally applicable. When the particle size of the primary particle is greater than 1000 nm, the surface reaction activity of the cathode material precursor is poor, the lattice strain of the prepared single-crystal cathode material is large, and the cycling performance and rate performance of the single-crystal cathode material are poor. The primary particle is less than 20 nm, and the tap density of the cathode material precursor is low, leading to low tap density of the prepared single-crystal cathode material. By controlling the particle size of the primary particle within the above range, the cycling performance and rate performance of the single-crystal cathode material prepared by the cathode material precursor are improved.

In some implementations, the average particle size $D_{50}$ of the cathode material precursor is <3.5 $\mu$m, which may specifically be 0.5 $\mu$m, 0.8 $\mu$m, 1.2 $\mu$m, 1.5 $\mu$m, 2 $\mu$m, 2.5 $\mu$m, 3 $\mu$m, 3.2 $\mu$m, 3.5 $\mu$m, or the like, or may definitely be other values within the above range, and is not limited herein. By controlling the particle size $D_{50}$ of the cathode material precursor within the above range, the reaction activity of the cathode material precursor is improved.

In some implementations, the specific surface area of the cathode material precursor is $\geq$5 $m^2$/g, which may specifically be 5 $m^2$/g, 6 $m^2$/g, 8 $m^2$/g, 10 $m^2$/g, 12 $m^2$/g, 15 $m^2$/g, 20 $m^2$/g, 25$m^2$/g, 50 $m^2$/g, 100 $m^2$/g, or the like, or may definitely be other values within the above range, and is not limited herein. If the specific surface area of the cathode material precursor is larger, the reaction activity of the cathode material precursor is higher, facilitating the reaction of the lithium source and the cathode material precursor, such that lattice defects of the single-crystal cathode material prepared by the cathode material precursor can be reduced.

In some implementations, a tap density of the cathode material precursor is >1g/$cm^3$, which may specifically be 1.1 g/$cm^3$, 1.2 g/$cm^3$, 1.3 g/$cm^3$, 1.8 g/$cm^3$, 2.3 g/$cm^3$, 2.5 g/$cm^3$, 3 g/$cm^3$, or may definitely be other values within the above range, and is not limited herein. By controlling the tap density of the cathode material precursor within the above range, the tap density of the prepared single-crystal cathode material is improved, thereby increasing an energy density of a battery.

In a third aspect, an embodiment of the present application provides a method for preparing a single-crystal cathode material, including the following steps.

At S100, atomization treatment is performed on a mixed solution containing a nickel salt, a cobalt salt, and a manganese salt, and then thermal decomposition is performed to obtain a cathode material precursor, where a surface area weighted average particle size of the cathode material precursor is D[3, 2] < 2.0 $\mu$m, and a standard deviation of a mass content of each element of Ni, Co, and Mn in the cathode material precursor is $\leq$0.05.

At S200, the cathode material precursor and a lithium source are mixed, and then placed under an oxygen-containing atmosphere for sintering, so as to obtain a cathode material, where a standard deviation of a mass content of each element of Ni, Co, and Mn in the single-crystal cathode material is $\leq$0.03; and lattice strain of the single-crystal cathode material is $\varepsilon$, and $\varepsilon$ < 0.2%.

According to the method for preparing a single-crystal cathode material provided in the present application, atomization treatment is performed on the mixed solution containing the nickel salt, the cobalt salt, and the manganese salt, and then thermal decomposition is performed to obtain the cathode material precursor. The surface area weighted average particle size of the cathode material precursor is D[3, 2] < 2.0 $\mu$m, such that reaction activity is high, and reaction efficiency and mass transfer efficiency of the cathode material precursor in the subsequent high-temperature sintering process with the lithium source are improved. Meanwhile, the standard deviation of the mass content of each element of Ni, Co, and Mn in the cathode material precursor obtained by the preparation method is $\leq$0.05, indicating that distribution uniformity of the Ni, Co, and Mn in the cathode material precursor is good. Then, the standard deviation of the mass content of each element of the Ni, Co, and Mn in the single-crystal cathode material prepared by subsequently sintering the cathode material precursor and the lithium source is $\leq$0.03, the distribution uniformity of Ni, Co, and Mn elements in the single-crystal cathode material is good, thereby facilitating reduction of the defects of the crystal structure of the single-crystal cathode material. The lattice strain of the single-crystal cathode material is reduced, and the lattice strain is $\varepsilon$ < 0.2%, such that diffusion energy barriers of lithium ions among microcrystal can be reduced, and Li ion diffusion coefficients are increased, thereby causing the single-crystal cathode material to show good rate performance and low DCR. Meanwhile, the generation of the microcracks in the single-crystal cathode material may also be inhibited by reducing lattice strain, thereby improving the cycling performance of the single-crystal cathode material.

At S100, atomization treatment is performed on the mixed solution containing the nickel salt, the cobalt salt, and the manganese salt, and then thermal decomposition is performed to obtain the cathode material precursor, where the surface area weighted average particle size of the cathode material precursor is D[3, 2] < 2.0 $\mu$m, and the standard deviation of the mass content of each element of Ni, Co, and Mn in the cathode material precursor is $\leq$0.05.

In particular, the surface area weighted average particle size D[3, 2] of the cathode material precursor may be 1.98 $\mu$m, 1.95 $\mu$m, 1.8 $\mu$m, 1.75 $\mu$m, 1.64 $\mu$m, 1.5 $\mu$m, 1.3 $\mu$m, 1.2 $\mu$m, 1.1 $\mu$m, 0.8 $\mu$m, 0.9 $\mu$m, 0.5 $\mu$m, and is not limited herein. By controlling the surface area weighted average particle size D[3, 2] of the cathode material precursor within the above range, the reaction activity of the cathode material precursor is high, facilitating improvement of the reaction efficiency and mass transfer efficiency of the cathode material precursor in the subsequent sinterining process with the lithium source. The surface area weighted average particle size D[3, 2] of the precursor is mainly related to a pyrolysis temperature. As the pyrolysis temperature increases, the surface area weighted average particle size D[3, 2] increases, and the reaction activity of the precursor is reduced.

The standard deviation of the mass content of each element of Ni, Co, and Mn in the cathode material precursor may specifically be 0.001, 0.005, 0.009, 0.01, 0.013, 0.02, 0.025, 0.03, 0.036, 0.01, 0.044, 0.045, 0.047, 0.049, or the like, and is not limited herein.

In some implementations, the nickel salt includes at least one of nickel chloride, nickel sulfate, nickel nitrate, nickel carbonate, nickel oxalate, or nickel acetate.

In some implementations, the cobalt salt includes at least one of cobalt chloride, cobalt oxalate, cobalt carbonate, cobalt sulfate, cobalt nitrate, or cobalt acetate.

In some implementations, the manganese salt includes at least one of manganese chloride, manganese carbonate, manganese sulfate, manganese oxalate, manganese nitrate, or manganese acetate.

In some implementations, a molar ratio of Ni, Co, to Mn in the mixed solution is (50-98):(0-20):(0-30), and the contents of the Co and Mn in the mixed solution are not 0. The molar ratio of the Ni, Co, and Mn in the mixed solution may specifically be 50:0.1:0.1, 60:10:30, 65:15:20, 65:5:30, 70:5:25, 70:10:20, 80:5:15, 85:10:5, 98:1:1, or the like, and is not limited herein.

In some implementations, a total metal concentration in the mixed solution is 200 g/L-500 g/L, which may specifically be 200 g/L, 220 g/L, 260 g/L, 300 g/L, 350 g/L, 400 g/L, 450 g/L, 480 g/L, 500 g/L, or the like, and may definitely be other values within the above range, and is not limited herein. The applicant found that, the metal concentration in the mixed solution can affect the preparation efficiency of the precursor and a degree of a thermal decomposition reaction. When the metal concentration of the mixed solution is too high, the precursor may not react completely, resulting in an unstable structure and non-ideal distribution uniformity of elements. When the metal concentration of the mixed solution is too low, the preparation efficiency is low, and many hollow spherical particles and broken situations easily occur when the mixed solution is rapidly evaporated at a high temperature, leading to non-ideal particle distribution and even more micro-powder particles affecting the performance of a material and a small number of large particles at the same time, and the large particles are more likely to cause a nonuniform distribution of elements, and simultaneously affects the surface area weighted average particle size D[3, 2] of the single-crystal cathode material precursor.

In some implementations, the mixed solution further includes a doping agent containing an N element, and N includes at least one of Al, Ti, Zr, Mg, Sr, Ba, Ca, Nb, W, Sb, Ta, Sn, or Y.

In some implementations, an ultrasonic dispersion stirring step is also included before the atomization treatment of the mixed solution, and ultrasonic stirring includes placing the mixed solution in a reactor having an ultrasonic stirring function for heating and ultrasonic stirring.

In some implementations, an ultrasonic stirring temperature is 50 °C-70 °C.

In some implementations, an ultrasonic frequency for ultrasonic stirring is 30 KHz-50 KHz, and the time for ultrasonic stirring is 0.5 h-2 h.

Performing heating and ultrasonic stirring before atomization can further fully mix chemical elements in the mixed solution, and more uniform fog droplets can be rapidly obtained, such that the precursor particles have a more uniform distribution of the elements on the surface during thermal decomposition, and have a smaller standard deviation mean value for mass content.

In some implementations, a surfactant is added before atomization treatment of the mixed solution, and the surfactant includes polyethylene glycol.

It may be understood that, when the polyethylene glycol is dissolved in water and reaches a certain concentration, surface tension of a system is reduced, the overall particle size of the cathode material precursor particles is smaller, element distribution is also more uniform, and the surface area weighted average particle size D[3, 2] of the single-crystal cathode material precursor is reduced.

In some implementations, the mass of the surfactant accounts for 0.5%-5% of the total mass of the mixed solution. The surfactant is within the above range, uniform cathode material precursor particles with smooth appearance and good dispersivity can be stably obtained. When a concentration is too low, the surfactant does not play a significant role, and when the concentration is too high, the overall concentration of a mixture is affected, resulting in precipitation of Ni, Co, Mn metal ions.

In some implementations, the ultrasonic dispersion stirring step is also included before the atomization treatment of the mixed solution; the mixed solution is placed in the reactor having an ultrasonic stirring function and heated to 50 °C-70 °C; the ultrasonic frequency for ultrasonic stirring is simultaneously adjusted to 30-50 KHz; ultrasonic stirring is performed for 0.5 h-2 h in the reactor, then a heating function is closed, and the polyethylene glycol of which mass is 0.5%-5% of the total mass of the mixed solution is added; and then ultrasonic stirring is performed for 0.5 h-1 h. In some implementations, a general chemical formula of the cathode material precursor is $Ni_aCo_bMn_cN_dO_e$, where $0.50 \leq a \leq 0.98$, $0 < b \leq 0.20$, $0 < c \leq 0.30$, $0 \leq d \leq 0.10$, $a+b+c+d=1$, $1 \leq e \leq 1.15$, and N includes at least one of Al, Ti, Zr, Mg, Sr, Ba, Ca, Nb, W, Sb, Ta, Sn, or Y.

In some implementations, the range of the mass content of each element of the Ni, Co, and Mn in the cathode material precursor is $\leq 0.12$, which may specifically be 0.01, 0.015, 0.018, 0.02, 0.029, 0.03, 0.035, 0.048, 0.059, 0.06, 0.08, 0.097, 0.10, 0.105, 0.11, 0.112, 0.115, 0.119, or the like, or, definitely, may also be other values within the above range, and is not limited herein.

It may be understood that, the standard deviation and range of the mass content of each element of Ni, Co, and Mn in the cathode material may reflect a degree of distribution uniformity of the Ni, Co, and Mn elements in the cathode material precursor. If the standard deviation and range of the mass content of each element of Ni, Co, and Mn are lower, the distribution of the Ni, Co, and Mn elements in the cathode material precursor is more uniform. Meanwhile, the distribution uniformity of the Ni, Co, and Mn elements in the cathode material precursor and the distribution uniformity of the Ni, Co, and Mn elements in the single-crystal cathode material have a good inheritance. If the distribution of the Ni, Co, and Mn elements in the cathode material precursor is more uniform, the distribution of the Ni, Co, and Mn elements in the single-crystal cathode material prepared by the cathode material precursor is also more uniform.

By controlling the standard deviation and range of the mass content of each element of Ni, Co, and Mn in the cathode material precursor within the above range, the distribution uniformity of the Ni, Co, and Mn elements in the single-crystal cathode material is improved to cause the distribution uniformity of the Ni, Co, and Mn elements in the single-crystal cathode material to be good, such that the single-crystal cathode material is less in defects of the crystal structure, and less in lattice strain.

In some implementations, a flow rate of the mixed solution is 100 L/h-900 L/h, which may specifically be 100 L/h, 200 L/h, 300 L/h, 400 L/h, 500 L/h, 600 L/h, 700 L/h, 800 L/h, 900 L/h, or the like, and is not limited herein. If the flow rate of the mixed solution is higher, a synthetic speed of the precursor is faster, but the distribution uniformity of Ni/Co/Mn deteriorates. When the flow rate is lower than 100 L/h, the synthesis efficiency of the precursor is low, and preparation costs are high; and when the flow rate of the mixed solution is higher than 900 L/h, the standard deviation and variance of the mass content of each element of Ni, Co, and Mn in the precursor are significantly increased, resulting in a reduction in the distribution uniformity of the Ni, Co, and Mn elements in the prepared single-crystal cathode material, and an increase in the lattice strain.

In some implementations, pressure for atomization treatment is 0.4 MPa-0.8 MPa, which may specifically be 0.4 MPa, 0.5 MPa, 0.6 MPa, 0.7 MPa, 0.75 MPa, 0.8 MPa, or the like, and may definitely be other values within the above range, and is not limited herein.

In some implementations, a temperature for thermal decomposition is 500 °C-850 °C, which may specifically be 500 °C, 550 °C, 600 °C, 650 °C, 700 °C, 750 °C, 800 °C, or the like, but is not limited to enumerated values, and other values not enumerated within the value range are equally applicable. As the temperature for thermal decomposition increases, the surface area weighted average particle size D[3, 2] of the cathode material precursor decreases, causing the activity of the precursor to reduce. When the temperature for thermal decomposition is higher than 850 °C, the surface area weighted average particle size D[3, 2] of the cathode material precursor is greater than 2.0 μm. In this case, the reaction activity of the cathode material precursor is poor, causing more defects in the subsequently prepared single-crystal cathode material, and the lattice strain ε exceeds 0.2%, causing the single-crystal cathode material to show poor rate performance, high DCR, and low cycling performance. Therefore, the reaction activity of the precursor is improved by properly reducing the temperature for thermal decomposition of the precursor, thereby improving the rate and DCR of the cathode material. However, when the temperature for thermal decomposition is less than 500 °C, decomposition of metal salts of Ni, Co, and Mn is incomplete, causing too high contents of negative ions such as Cl⁻, $NO_3^-$, $CO_3^{2-}$, etc. of the precursor; and in the process of subsequently preparing the cathode material, these residual negative ions inhibit the formation of monocrystalline, and corrode a sintering kiln.

At S200, the cathode material precursor and a lithium source are mixed, and then placed under an oxygen-containing atmosphere for sintering, so as to obtain a cathode material, where a standard deviation of a mass content of each element of Ni, Co, and Mn in the single-crystal cathode material is $\leq 0.03$; and lattice strain of the single-crystal cathode material is ε, and ε < 0.2%.

In some implementations, the lithium source includes at least one of lithium carbonate, lithium hydroxide, lithium acetate, lithium sulfate, lithium chloride, lithium nitrate, or lithium oxalate.

In some implementations, a molar ratio of lithium in the lithium source to the sum of nickel, cobalt, and manganese in the cathode material precursor is 0.98-1.10, which may specifically be 0.98, 0.99, 1.01, 1.03, 1.05, 1.06, 1.08, 1.09, 1.10, or the like, and may definitely be other values within the above range, and is not limited herein.

In some implementations, a temperature for a sintering reaction is 750 °C-950 °C, which may specifically be 750 °C, 760 °C, 780 °C, 800 °C, 850 °C, 900 °C, 920 °C, 950 °C, or the like, and may definitely be other values within the above range, and is not limited herein. The sintering temperature is closely related to a Ni content, and if the Ni content is higher, the sintering temperature is lower. Furthermore, an appropriate sintering temperature facilitates a reduction in defects of the crystal structure, so as to reduce the lattice strain, thereby improving the electrochemical performance of the single-crystal cathode material.

In some implementations, a time for the sintering reaction is 10 h-30 h, which may specifically be 10 h, 12 h, 15 h, 16 h, 18 h, 20 h, 24 h, 28 h, 30 h, or the like, and may definitely be other values within the above range, and is not limited herein.

In a fourth aspect, an embodiment of the present application provides a lithium ion battery. The lithium ion battery includes the single-crystal cathode material described in the first aspect or a cathode material prepared by the method for preparing a single-crystal cathode material described in the third aspect.

The beneficial effects of the present application are further described below with reference to the embodiments and comparative examples.

Embodiment 1

(1) Nickel chloride, cobalt chloride, and manganese chloride were weighed according to a molar ratio ($n_{Ni}:n_{Co}:n_{Mn}$=0.67:0.05:0.28), and added to water to prepare into a mixed solution; a total metal concentration of the mixed solution was controlled to be 300 g/L; the mixed solution was placed in a reactor having an ultrasonic stirring function and heated to 60 °C; an ultrasonic frequency for ultrasonic stirring was adjusted to 33 KHz at the same time; ultrasonic stirring was performed for 1 h in the reactor, then a heating function was closed, polyethylene glycol of which mass was 1% of a total mass of the mixed solution was added, and then ultrasonic stirring was performed for 0.5 h; and based on the total mass of Ni, Co, and Mn elements, a content of $SO_4^{2-}$ was 900 ppm.

(2) The mixed solution was atomized into droplets, and then placed in a baking furnace under an air atmosphere to perform thermal decomposition at 650 °C; and a flow rate of the mixed solution was controlled to be 200 L/h, and an atomization pressure was 0.6 MPa.

(3) Jet milling was performed on the thermal decomposition product to obtain a cathode material precursor ($Ni_{0.67}Co_{0.05}Mn_{0.28}O$).

(4) The cathode material precursor and lithium carbonate were weighed according to a molar ratio ($n_{Ni+Co+Mn}:n_{Li}$=1:1), well mixed, then placed under the oxygen atmosphere, heated to 920 °C, and sintered for 20 h, so as to obtain a single-crystal cathode material.

A general chemical formula of the single-crystal cathode material prepared in this embodiment was Li-$Ni_{0.67}Co_{0.05}Mn_{0.28}O_2$, an average particle size $D_{50}$ of the single-crystal cathode material was 3.8 μm, and a tap density was 1.95 g/cm³.

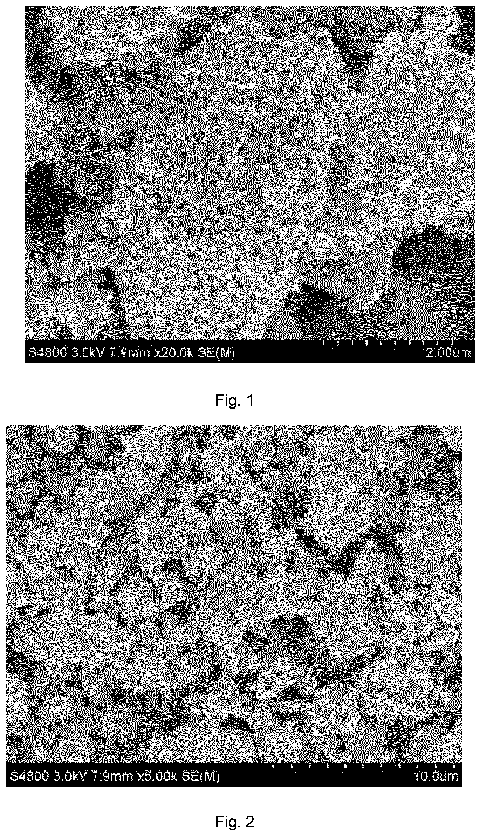

Fig. 1 is an SEM topography of a cathode material precursor prepared according to Embodiment 1 of the present application; and Fig. 2 is another SEM topography of a cathode material precursor prepared according to Embodiment 1 of the present application. As shown in Fig. 1 and Fig. 2, the cathode material precursor included a secondary particle, and the secondary particle included a plurality of agglomerated primary particles.

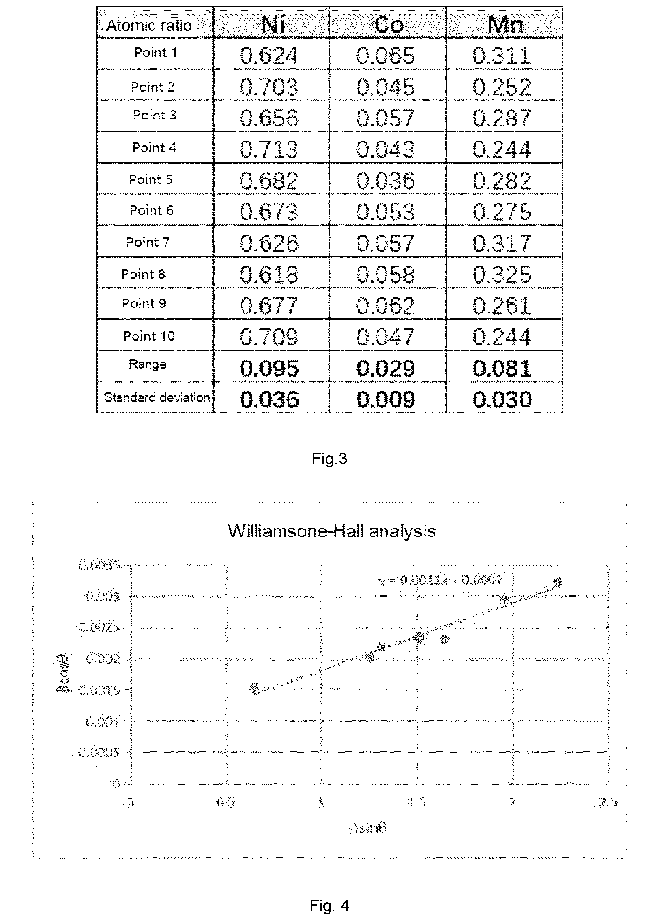

When an SEM was used to observe the cathode material precursor prepared in Embodiment 1 of the present application, at a magnification of 3K, 10 points were randomly selected for the cathode material precursor to perform an EDS point scanning so as to test contents of Ni, Co, and Mn, and in EDS spectrum results of the cathode material precursor, as shown in Fig. 3, a range of the Ni content in the cathode material precursor was 0.095, and a standard deviation was 0.036; a range of the Co content was 0.029, and a standard deviation was 0.009; and a range of the Mn content was 0.081, and a standard deviation was 0.030. It indicated that distribution uniformity of the Ni, Co, and Mn in the cathode material precursor prepared in Embodiment 1 was good. In addition, through ion chromatography detection, the content of free $SO_4^{2-}$ on a surface of the cathode material precursor was 504 ppm.

Fig. 4 is a Williamsone-Hall analysis fitting curve of a single-crystal cathode material prepared according to Embodiment 1 of the present application. As shown in Fig. 4, lattice strain of the single-crystal cathode material might be 0.11% by analyzing and calculating data in Fig. 4. Other performance parameters of the cathode material precursor and single-crystal cathode material were shown in detail in Table 1 and Table 2.

Embodiment 2

Differences between this embodiment and Embodiment 1 lied in that, (2) the mixed solution was atomized into droplets, and then placed in a baking furnace under an air atmosphere to perform thermal decomposition at 750 °C; and a flow rate of the mixed solution was controlled to be 200 L/h, and an atomization pressure was 0.6 MPa.

A general chemical formula of the single-crystal cathode material prepared in this embodiment was $LiNi_{0.67}Co_{0.05}Mn_{0.28}O_2$, an average particle size $D_{50}$ of the single-crystal cathode material was 3.7 $\mu$m, and a tap density was 1.85 g/cm$^3$.

Other performance parameters of the cathode material precursor and single-crystal cathode material were shown in detail in Table 1 and Table 2.

Embodiment 3

Differences between this embodiment and Embodiment 1 lied in that, (2) the mixed solution was atomized into droplets, and then placed in a baking furnace under an air atmosphere to perform thermal decomposition at 650 °C; and a flow rate of the mixed solution was controlled to be 100 L/h, and an atomization pressure was 0.6 MPa.

A general chemical formula of the single-crystal cathode material prepared in this embodiment was $LiNi_{0.67}Co_{0.05}Mn_{0.28}O_2$, an average particle size $D_{50}$ of the single-crystal cathode material was 4.0 $\mu$m, and a tap density was 2.12 g/cm$^3$.

Other performance parameters of the cathode material precursor and single-crystal cathode material were shown in detail in Table 1 and Table 2.

Embodiment 4

Differences between this embodiment and Embodiment 1 lied in that, (2) the mixed solution was atomized into droplets, and then placed in a baking furnace under an air atmosphere to perform thermal decomposition at 500 °C; and a flow rate of the mixed solution was controlled to be 500 L/h, and an atomization pressure was 0.6 MPa.

A general chemical formula of the single-crystal cathode material prepared in this embodiment was $LiNi_{0.67}Co_{0.05}Mn_{0.28}O_2$, an average particle size $D_{50}$ of the single-crystal cathode material was 3.8 $\mu$m, and a tap density was 1.90 g/cm$^3$.

Other performance parameters of the cathode material precursor and single-crystal cathode material were shown in detail in Table 1 and Table 2.

Embodiment 5

Differences between this embodiment and Embodiment 1 lied in that, (4) the cathode material precursor and lithium carbonate were weighed according to a molar ratio ($n_{Ni+Co+Mn}:n_{Li}$=1:1), well mixed, then placed under the oxygen atmosphere, heated to 950 °C, and sintered for 20 h, so as to obtain a single-crystal cathode material.

A general chemical formula of the single-crystal cathode material prepared in this embodiment was $LiNi_{0.67}Co_{0.05}Mn_{0.28}O_2$, an average particle size $D_{50}$ of the single-crystal cathode material was 4.5 $\mu$m, and a tap density was 2.2 g/cm$^3$.

Other performance parameters of the cathode material precursor and single-crystal cathode material were shown in detail in Table 1 and Table 2.

Embodiment 6

Differences between this embodiment and Embodiment 1 lied in that, (4) the cathode material precursor and lithium carbonate were weighed according to a molar ratio ($n_{Ni+Co+Mn}:n_{Li}$=1:1), well mixed, then placed under the oxygen atmosphere, heated to 900 °C, and sintered for 20 h, so as to obtain a single-crystal cathode material.

A general chemical formula of the single-crystal cathode material prepared in this embodiment was $LiNi_{0.67}Co_{0.05}Mn_{0.28}O_2$, an average particle size $D_{50}$ of the single-crystal cathode material was 3.0 $\mu$m, and a tap density was 1.68 g/cm$^3$.

Other performance parameters of the cathode material precursor and single-crystal cathode material were shown in detail in Table 1 and Table 2.

Embodiment 7

(1) Nickel chloride, cobalt chloride, and manganese chloride were weighed according to a molar ratio ($n_{Ni}$:$n_{Co}$:$n_{Mn}$=0.88:0.06:0.04), and added to water to prepare into a mixed solution; a total metal concentration of the mixed solution was controlled to be 300 g/L; and based on the total mass of Ni, Co, and Mn elements, a content of $SO_4^{2-}$ was ≤1780 ppm.

(2) The mixed solution was atomized into droplets, and then placed in a baking furnace under an air atmosphere to perform thermal decomposition at 600 °C; and a flow rate of the mixed solution was controlled to be 200 L/h, and an atomization pressure was 0.6 MPa.

(3) Jet milling was performed on the thermal decomposition product to obtain a cathode material precursor ($Ni_{0.88}Co_{0.06}Mn_{0.04}O$).

(4) The cathode material precursor and lithium carbonate were weighed according to a molar ratio ($n_{Ni+Co+Mn}$:$n_{Li}$=1:1), well mixed, then placed under the oxygen atmosphere, heated to 850 °C, and sintered for 15 h, so as to obtain a single-crystal cathode material.

A general chemical formula of the single-crystal cathode material prepared in this embodiment was Li-$Ni_{0.88}Co_{0.06}Mn_{0.04}O_2$, an average particle size $D_{50}$ of the single-crystal cathode material was 3.2 μm, and a tap density was 1.77 g/cm$^3$.

Other performance parameters of the cathode material precursor and single-crystal cathode material were shown in detail in Table 1 and Table 2.

Embodiment 8

(1) Nickel chloride, cobalt chloride, manganese chloride, aluminum chloride were weighed according to a molar ratio ($n_{Ni}$:$n_{Co}$:$n_{Mn}$:$n_{Al}$=0.88:0.06:0.03:0.03), and added to water to prepare into a mixed solution; and a total metal concentration of the mixed solution was controlled to be 300 g/L.

(2) The mixed solution was atomized into droplets, and then placed in a baking furnace under an air atmosphere to perform thermal decomposition at 600 °C; and a flow rate of the mixed solution was controlled to be 200 L/h, and an atomization pressure was 0.6 MPa.

(3) Jet milling was performed on the thermal decomposition product to obtain a cathode material precursor ($Ni_{0.88}Co_{0.06}Mn_{0.03}Al_{0.03}O$).

(4) The cathode material precursor and lithium hydroxide were weighed according to a molar ratio ($n_{Ni+Co+Mn+Al}$:$n_{Li}$=1:1), well mixed, then placed under the oxygen atmosphere, heated to 850 °C, and sintered for 15 h, so as to obtain a cathode material.

A general chemical formula of the single-crystal cathode material prepared in this embodiment was Li-$Ni_{0.88}Co_{0.06}Mn_{0.03}Al_{0.03}O_2$, an average particle size $D_{50}$ of the single-crystal cathode material was 3.2 μm, and a tap density was 1.78 g/cm$^3$.

Other performance parameters of the cathode material precursor and single-crystal cathode material were shown in detail in Table 1 and Table 2.

Embodiment 9

Differences between this embodiment and Embodiment 1 lied in that, (1) based on the total mass of Ni, Co, and Mn elements, a content of $SO_4^{2-}$ was 200 ppm. Through ion chromatography detection, the content of free $SO_4^{2-}$ on a surface of the cathode material precursor prepared in this embodiment was 100 ppm. A general chemical formula of the single-crystal cathode material prepared in this embodiment was $LiNi_{0.67}Co_{0.05}Mn_{0.28}O_2$, an average particle size $D_{50}$ of the single-crystal cathode material was 3.8 μm, and a tap density was 1.95 g/cm$^3$. Other performance parameters of the cathode material precursor and single-crystal cathode material were shown in detail in Table 1 and Table 2.

Embodiment 10

Differences between this embodiment and Embodiment 1 lied in that, (1) nickel chloride, cobalt chloride, and manganese chloride were weighed according to a molar ratio ($n_{Ni}$:$n_{Co}$:$n_{Mn}$=0.67:0.05:0.28), and added to water to prepare into a mixed solution; a total metal concentration of the mixed solution was controlled to be 500 g/L; polyethylene glycol of which mass is 5% of the total mass of the mixed solution was added; and based on the total mass of Ni, Co, and Mn elements, a content of $SO_4^{2-}$ was 900 ppm.

A general chemical formula of the single-crystal cathode material prepared in this embodiment was Li-

$Ni_{0.67}Co_{0.05}Mn_{0.28}O_2$, an average particle size D50 of the single-crystal cathode material was 3.8 $\mu$m, and a tap density was 1.83 g/cm³. Other performance parameters of the cathode material precursor and single-crystal cathode material were shown in detail in Table 1 and Table 2.

Embodiment 11

Differences between this embodiment and Embodiment 1 lied in that, (1) nickel chloride, cobalt chloride, and manganese chloride were weighed according to a molar ratio ($n_{Ni}$:$n_{Co}$:$n_{Mn}$=0.67:0.05:0.28), and added to water to prepare into a mixed solution; a total metal concentration of the mixed solution was controlled to be 200 g/L; the mixed solution was placed in a reactor having an ultrasonic stirring function and heated to 60 °C; an ultrasonic frequency for ultrasonic stirring was adjusted to 33 KHz at the same time; ultrasonic stirring was performed for 1 h in the reactor; and based on the total mass of Ni, Co, and Mn elements, a content of $SO_4^{2-}$ was 900 ppm.

A general chemical formula of the single-crystal cathode material prepared in this embodiment was Li-$Ni_{0.67}Co_{0.05}Mn_{0.28}O_2$, an average particle size D50 of the single-crystal cathode material was 4.1 $\mu$m, and a tap density was 1.82 g/cm³. Other performance parameters of the cathode material precursor and single-crystal cathode material were shown in detail in Table 1 and Table 2.

Comparative example 1

Differences between this comparative example and Embodiment 1 lied in that, (2) the mixed solution was atomized into droplets, and then placed in a baking furnace under an air atmosphere to perform thermal decomposition at 880 °C; and a flow rate of the mixed solution was controlled to be 200 L/h, and an atomization pressure was 0.6 MPa.

A general chemical formula of the single-crystal cathode material prepared in this comparative example was $LiNi_{0.67}Co_{0.05}Mn_{0.28}O_2$, an average particle size D50 of the cathode material was 3.82 $\mu$m, and a tap density was 1.86 g/cm³.

Other performance parameters of the cathode material precursor and single-crystal cathode material were shown in detail in Table 1 and Table 2.

Comparative example 2

Differences between this comparative example and Embodiment 1 lied in that, (2) the mixed solution was atomized into droplets, and then placed in a baking furnace under an air atmosphere to perform thermal decomposition at 650 °C; and a flow rate of the mixed solution was controlled to be 1000 L/h, and an atomization pressure was 0.6 MPa.

A general chemical formula of the single-crystal cathode material prepared in this comparative example was $LiNi_{0.67}Co_{0.05}Mn_{0.28}O_2$, an average particle size D50 of the single-crystal cathode material was 3.72 $\mu$m, and a tap density was 1.90 g/cm³.

Other performance parameters of the cathode material precursor and single-crystal cathode material were shown in detail in Table 1 and Table 2.

Comparative example 3

Differences between this comparative example and Embodiment 1 lied in that, (4) the cathode material precursor and lithium carbonate were weighed according to a molar ratio ($n_{Ni+Co+Mn}$:$n_{Li}$=1:1), well mixed, then placed under the oxygen atmosphere, heated to 700 °C, and sintered for 20 h, so as to obtain a cathode material.

The cathode material prepared in this comparative example was a polycrystalline cathode material, with a general chemical formula being $LiNi_{0.67}Co_{0.05}Mn_{0.28}O_2$, an average particle size D50 of the polycrystalline cathode material was 3.2 $\mu$m, and a tap density was 1.8 g/cm³.

Other performance parameters of the cathode material precursor and single-crystal cathode material were shown in detail in Table 1 and Table 2.

Comparative example 4

Referring to a $Ni_{0.88}Co_{0.06}Mn_{0.03}Al_{0.03}(OH)_2$ quaternary precursor and corresponding cathode materials prepared in Embodiment 2 of CN113488642A.

(1) Preparation of a first solution: nickel sulfate hexahydrate, manganese(II) sulfate monohydrate, and cobalt sulfate heptahydrate were weighed according to a molar ratio being nickel:cobalt:manganese = 0.88:0.06:0.03, dissolved by using deionized water, and prepared into a transition metal salt solution with a mass concentration of 2 mol/L, which was referred to as the first solution.

(2) Preparation of a second solution: aluminum nitrate nonahydrate was weighed and dissolved in the deionized water; then concentrated ammonia solution with a mass concentration of 25% was added dropwise to the aluminum salt solution and stirred continuously; the concentrated ammonia solution stopped to be added when pH = 8-9; and finally, a volume was fixed to a concentration of aluminum hydroxide being 0.11 mol/L, which was referred to as the second solution.

(3) Preparation of a quaternary transition metal hydroxide precursor: an ammonia water base solution was added to a reactor in advance, a temperature of a reaction system was controlled at 55 °C, and a speed of a stirring paddle was adjusted to 1000 rpm. A No.1 metering pump was used to add the first solution to the reactor at a speed of 35 L/h; a No. 2 metering pump was used to add the second solution to the reactor at a speed of 20 L/h; a No. 3 metering pump was used to add the ammonia water solution to maintain a concentration of the ammonia water in the system at 0.5 mol/L; and a No. 4 metering pump was used to add a 4mol/L sodium hydroxide solution, so as to control the pH of the reaction system to be $10.0\pm0.5$. Materials were continuously added for reaction for 17 h, aging was performed for 10 h, then a final precipitate product was filtrated and washed, dried in a 110 °C oven for 12 h, and then smashed and sieved to obtain a $Ni_{0.88}Co_{0.06}Mn_{0.03}Al_{0.03}(OH)_2$ hydroxide precursor.

(4) The hydroxide precursor and lithium hydroxide were well mixed according to a molar ratio of 1:1.05, sintered for 3 h at 500 °C under the oxygen atmosphere, and sintered for 15 h at 850 °C; and a product was crushed and sieved after cooling, until D50 was 12 μm, so as to obtain a single-crystal cathode material $LiNi_{0.88}Co_{0.06}Mn_{0.03}Al_{0.03}O_2$.

Other performance parameters of the cathode material precursor and single-crystal cathode material were shown in detail in Table 1 and Table 2.

Comparative example 5

Referring to a $Ni_{0.8}Co_{0.1}Mn_{0.1}(OH)_2$ precursor and corresponding cathode materials prepared in CN116230922A.

(1) $NiSO_4$, $CoSO_4$, and $MnSO_4$ were mixed according to a Ni/Co/Mn molar ratio of 0.8:0.1:0.1, and prepared into a solution.

(2) The solution was added to a 55 °C reactor, and a co-precipitation reaction was performed for 36 hours by using NaOH and $NH_3\cdot H_2O$ as a precipitant and a chelating agent, so as to obtain the $Ni_{0.8}Co_{0.1}Mn_{0.1}(OH)_2$ precursor.

(3) The precursor was dried for 12 hours at 80 °C, and then dried again for 12 hours at 110 °C.

(4) The precursor and lithium hydroxide were added to a dry-type high-speed mixer according to a molar ratio of 1:1.05, and mixed for 5 min.

(5) A temperature was heated to 950 °C at a heating rate of 2 °C/min, held for 5 hours at 950 °C, then cooled naturally to 900 °C, and held for 5 hours. Oxygen was introduced at a flow rate of 10 mL/min during heating and temperature-holding. After calcination was completed, the temperature was naturally cooled to room temperature, and crushing and grading were performed to prepare a $LiNi_{0.8}CO_{0.1}Mn_{0.1}O_2$ single-crystal cathode material.

Other performance parameters of the cathode material precursor and single-crystal cathode material were shown in detail in Table 1 and Table 2.

Comparative example 6

Differences between this comparative example and Embodiment 1 lied in that, (1) based on the total mass of Ni, Co, and Mn elements, a content of $SO_4^{2-}$ was 2000 ppm.

The content of free $SO_4^{2-}$ on a surface of the precursor prepared in this embodiment was 1200 ppm. A general chemical formula of the single-crystal cathode material prepared in this embodiment was $LiNi_{0.67}Co_{0.05}Mn_{0.28}O_2$, an average particle size $D_{50}$ of the single-crystal cathode material was 3.8 μm, and a tap density was 1.95 g/cm$^3$. Other performance parameters of the cathode material precursor and single-crystal cathode material were shown in detail in Table 1 and Table 2.

Test method:

(1) At a magnification of 3K, 10 points were randomly selected from a surface of an untreated cathode material precursor or single-crystal cathode material by using an EDS attached to an SEM for scanning, so as to test Ni, Co, and Mn contents of the cathode material precursor or single-crystal cathode material, a standard deviation and range of a mass content of each element of Ni, Co, and Mn were counted to represent distribution uniformity of the Ni, Co, and Mn elements.

(2) A Malvern 3000 laser particle analyzer was used for testing, so as to obtain a surface area weighted average particle size D[3, 2] of the cathode material precursor.

(3) Lattice strain and grain size of the single-crystal cathode material were obtained by XRD data through Williamsone-Hall analysis and calculation.

Details included: a Rigaku X-ray diffractometer was used for measurement; and specific conditions included: 0.75 degrees per minute, a step size being 0.02, and continuous scanning between 10 and 90 degrees within a 2θ range. A curve using $4\sin\theta_{hkl}$ as a horizontal ordinate and $\beta_{hkl}\cos\theta_{hkl}$ as a longitudinal coordinate was drawn and fitted, and the strain ε and the grain size D might be calculated through a slope and an intercept. It was to be noted that, a half peak width $\beta_{hkl}$ used for fitting needed to exclude the effects of instruments, that is, $\beta_{hkl}=\beta_{total}-\beta_{instrument}$, where $\beta_{total}$ is a half peak width value actually tested, $\beta_{instrument}$ is the broadening of the half peak width caused by the instruments, and the numerical value might be calculated by testing the XRD of a standard silicon wafer. $\beta_{instrument}$ of a test device used in the present application is 0.000103. In addition, data of 7 stronger diffraction peaks of (003), (101), (102), (104), (015), (107), and (113) was used for fitting, so as to improve a degree of linear fitting, thereby reducing testing errors.

$$\beta_{hkl} \cos\theta_{hkl} = \frac{k\lambda}{D} + 4\varepsilon\sin\theta_{hkl}$$

β was the half peak width, θ was a diffraction angle, both in radians; k was a constant, and was 0.89; λ was an X-ray wavelength, and was 0.154 nm; and D was the grain size, in nm. ε was the lattice strain and was dimensionless.

(4) A tap density meter was used, a certain amount of a sample was weighed, and vibration was performed for 3000 times at 300 times/min to test a tap density.

(5) Electrochemical performance test:

A button half battery was used to evaluate the electrochemical performance of a material. Details were as follows: a single-crystal cathode material, conductive carbon black, and PVDF were weighed according to a mass ratio of 93:5:2, N-methyl-2-pyrrolidone (NMP) was added according to 50% of a solid content, a high-speed disperser was used to make viscous slurry, the slurry was uniformly coated on aluminum foil by using a scraper, and the aluminum foil was dried in a 80 °C oven, rolled, and cut into a cathode plate with a diameter of 14 mm. A 16 mm lithium sheet was used as a anode plate, a Celgard polypropylene film was used as a diaphragm, a $LiPF_6$ carbonate solution with a concentration of 1 mol/L was used as electrolyte, and assembly was performed in a glove box filled with argon, so as to obtain the button half battery. A LAND battery test system was used to perform capacity and cycling performance tests at 25 °C and 3.0-4.3 V, and a nominal capacity 1C was set to 200 mAh/g. In addition, a voltage UA at an initial discharging moment and voltage data UB at 60s, as well as a discharging current IDis, were recorded each week, and a calculation formula of DCR was $DCR=(U_A-U_B)/I_{Dis}$.

(6) $SO_4^{2-}$ content test:

0.5 g cathode material sample was taken and dissolved in 50 mL of water, ultrasonic was performed for 5 min, then filtration was performed, and ion chromatography (Thermo Fisher Ion Chromatography ICS6000 HPIC) was used to measure the content of $SO_4^{2-}$ ions in filtrate.

(7) EBSD test:

A cathode material sample was first embedded in a carbon paint (PELCO) graphite block, and then a cross section of the block was polished by using an argon ion beam. A JEOL JSM-7000F SEM was used to perform EBSD imaging. A step size of an EBSD diagram was set to 250 nm (each pixel being 250 nm×250 nm).

Test results were shown in detail in Table 1-Table 3.

Table 1 Performance parameter results for cathode material precursor prepared in embodiments and comparative examples

| | Cathode material precursor | | Range of mass content of each element of Ni, Co, and Mn | | | Standard deviation of mass content of each element of Ni, Co, and Mn | | |
|---|---|---|---|---|---|---|---|---|
| | $SO_4^{2-}$-content /ppm | D[3,2] /μm | Ni | Co | Mn | Ni | Co | Mn |
| Embodime nt 1 | 504 | 1.5 | 0.095 | 0.029 | 0.081 | 0.036 | 0.009 | 0.030 |
| Embodime nt 2 | 505 | 1.9 | 0.095 | 0.029 | 0.081 | 0.036 | 0.009 | 0.030 |
| Embodime nt 3 | 500 | 1.9 | 0.078 | 0.025 | 0.062 | 0.018 | 0.007 | 0.016 |
| Embodime nt 4 | 502 | 1.5 | 0.115 | 0.052 | 0.102 | 0.049 | 0.020 | 0.042 |
| Embodime nt 5 | 504 | 1.5 | 0.095 | 0.029 | 0.081 | 0.036 | 0.009 | 0.030 |
| Embodime nt 6 | 504 | 1.5 | 0.095 | 0.029 | 0.081 | 0.036 | 0.009 | 0.030 |
| Embodime nt 7 | 950 | 1.5 | 0.095 | 0.030 | 0.090 | 0.036 | 0.010 | 0.029 |
| Embodime nt 8 | 950 | 1.5 | 0.090 | 0.029 | 0.080 | 0.035 | 0.009 | 0.028 |
| Embodime nt 9 | 100 | 1.5 | 0.095 | 0.029 | 0.081 | 0.036 | 0.009 | 0.030 |
| Embodime nt 10 | 503 | 1.6 | 0.115 | 0.066 | 0.163 | 0.049 | 0.027 | 0.047 |
| Embodime nt 11 | 502 | 1.9 | 0.105 | 0.067 | 0.087 | 0.041 | 0.028 | 0.033 |
| Comparati ve example 1 | 504 | 2.5 | 0.095 | 0.029 | 0.081 | 0.036 | 0.009 | 0.030 |
| Comparati ve example 2 | 510 | 1.5 | 0.150 | 0.085 | 0.120 | 0.060 | 0.042 | 0.050 |
| Comparati ve example 3 | 504 | 1.5 | 0.095 | 0.029 | 0.081 | 0.036 | 0.009 | 0.030 |
| Comparati ve example 4 | 3000 | 9.2 | 0.160 | 0.010 | 0.120 | 0.080 | 0.062 | 0.075 |
| Comparati ve example 5 | 5000 | 3.5 | 0.130 | 0.090 | 0.150 | 0.072 | 0.060 | 0.085 |
| Comparati ve example 6 | 1200 | 1.5 | 0.095 | 0.029 | 0.081 | 0.036 | 0.009 | 0.030 |

Table 2 Performance parameter results for single-crystal cathode material prepared in embodiments and comparative examples

| | Cathode material | | | Range of mass content of each element of Ni, Co, and Mn | | | Standard deviation of mass content of each element of Ni, Co, and Mn | | | Contai ning single crystal grains with same orienta tion or not | Average particle size of single crystal grain/μm |
|---|---|---|---|---|---|---|---|---|---|---|---|
| | /ppm $SO_4^{2-}$ content /ppm | Lattice strain ε | Grain size/nm | Ni | Co | Mn | Ni | Co | Mn | | |
| Embodime nt 1 | 495 | 0.11% | 196 | 0.050 | 0.023 | 0.053 | 0.015 | 0.007 | 0.015 | Yes | 2.1 |
| Embodime nt 2 | 495 | 0.17% | 192 | 0.050 | 0.023 | 0.053 | 0.015 | 0.007 | 0.015 | Yes | 2.0 |
| Embodime nt 3 | 490 | 0.15% | 192 | 0.042 | 0.020 | 0.032 | 0.012 | 0.006 | 0.013 | Yes | 2.0 |
| Embodime nt 4 | 494 | 0.18% | 192 | 0.078 | 0.048 | 0.069 | 0.028 | 0.012 | 0.024 | Yes | 2.2 |

(continued)

| | Cathode material | | | | Range of mass content of each element of Ni, Co, and Mn | | | Standard deviation of mass content of each element of Ni, Co, and Mn | | | Containing single crystal grains with same orientation or not | Average particle size of single crystal grain/$\mu$m |
|---|---|---|---|---|---|---|---|---|---|---|---|---|
| | /ppm SO$_4{}^{2-}$ content /ppm | Lattice strain $\varepsilon$ | Grain size/nm | | Ni | Co | Mn | Ni | Co | Mn | | |
| Embodiment 5 | 475 | 0.09% | 249 | | 0.040 | 0.018 | 0.035 | 0.010 | 0.005 | 0.011 | Yes | 4.0 |
| Embodiment 6 | 500 | 0.19% | 151 | | 0.068 | 0.030 | 0.062 | 0.025 | 0.010 | 0.020 | Yes | 1.2 |
| Embodiment 7 | 935 | 0.17% | 198 | | 0.066 | 0.026 | 0.076 | 0.024 | 0.011 | 0.021 | Yes | 3.0 |
| Embodiment 8 | 940 | 0.16% | 196 | | 0.065 | 0.025 | 0.070 | 0.022 | 0.010 | 0.020 | Yes | 1.8 |
| Embodiment 9 | 85 | 0.11% | 205 | | 0.050 | 0.023 | 0.053 | 0.015 | 0.007 | 0.015 | Yes | 2.1 |
| Embodiment 10 | 494 | 0.19 | 197 | | 0.078 | 0.034 | 0.73 | 0.029 | 0.015 | 0.027 | Yes | 2.1 |
| Embodiment 11 | 492 | 0.19 | 197 | | 0.069 | 0.036 | 0.77 | 0.028 | 0.018 | 0.023 | Yes | 3.2 |
| Comparative example 1 | 500 | 0.25% | 185 | | 0.050 | 0.023 | 0.053 | 0.015 | 0.007 | 0.015 | Yes | 1.9 |
| Comparative example 2 | 502 | 0.30% | 196 | | 0.090 | 0.062 | 0.082 | 0.036 | 0.020 | 0.032 | Yes | 2.1 |
| Comparative example 3 | 503 | 0.23% | 120 | | 0.075 | 0.025 | 0.065 | 0.029 | 0.008 | 0.026 | No | / |
| Comparative example 4 | 2700 | 0.42% | 185 | | 0.105 | 0.080 | 0.090 | 0.050 | 0.032 | 0.043 | Yes | 2.1 |
| Comparative example 5 | 4500 | 0.35% | 196 | | 0.090 | 0.060 | 0.100 | 0.035 | 0.020 | 0.042 | Yes | 2.1 |
| Comparative example 6 | 1100 | 0.11% | 196 | | 0.050 | 0.023 | 0.053 | 0.015 | 0.007 | 0.015 | Yes | 2.0 |

Table 3 Electrochemical performance test results for single-crystal cathode material prepared in embodiments and comparative examples

| | 0.1C capacity (mAh/g) | 1C capacity (mAh/g) | Ratio of 1C capacity to 0.1C capacity | Capacity fading at 1C after 50 cycles | DCR (mΩ) |
|---|---|---|---|---|---|
| Embodi ment 1 | 185.5 | 165.2 | 89.1% | 4.5% | 20.5 |
| Embodi ment 2 | 185.5 | 162.0 | 87.5% | 7.5% | 27.0 |
| Embodi ment 3 | 185.1 | 163.2 | 88.2% | 6.0% | 25.2 |
| Embodi ment 4 | 185.2 | 161.2 | 87.0% | 7.8% | 28.2 |
| Embodi ment 5 | 185.5 | 163.7 | 88.2% | 4.2% | 25.5 |
| Embodi ment 6 | 185.3 | 164.0 | 88.5% | 6.5% | 21.9 |
| Embodi ment 7 | 219.2 | 194.9 | 88.9% | 6.0% | 21.8 |
| Embodi ment 8 | 217.8 | 194.0 | 89.1% | 5.2% | 21.2 |
| Embodi ment 9 | 185.6 | 166.1 | 89.5% | 4.2% | 18.5 |
| Embodi ment 10 | 185.2 | 163.8 | 88.4% | 6.6% | 26.8 |
| Embodi ment 11 | 185.8 | 163.7 | 88.1% | 6.5% | 27.0 |
| Compara tive example 1 | 185.5 | 161.0 | 86.8% | 8.0% | 29.4 |
| Compara tive example 2 | 185.5 | 160.2 | 86.4% | 8.5% | 30.1 |
| Compara tive example 3 | 186.9 | 167.2 | 89.2% | 20.1% | 18.5 |
| Compara tive example 4 | 217.6 | 186.0 | 85.5% | 10.0% | 32.2 |
| Compara tive example 5 | 210.8 | 185.0 | 86.1% | 9.0% | 31.9 |
| Compara tive example 6 | 185.0 | 164.0 | 88.6% | 5.5% | 25.2 |

According to test data in Tables 1-3, it might be learned that in the single-crystal cathode material prepared in Embodiments 1-8, the standard deviation of the mass content of each element of Ni, Co, and Mn in the single-crystal cathode material was ≤0.03, and the range of the mass content of each element of Ni, Co, and Mn was ≤0.08, indicating that distribution uniformity of Ni, Co, and Mn elements in the single-crystal cathode material was good, thereby facilitating reduction of defects of a crystal structure of the single-crystal cathode material. The lattice strain of the single-crystal cathode material was $\varepsilon < 0.2\%$, such that diffusion energy barriers of lithium ions among crystallite could be reduced, and Li ion diffusion coefficients were increased, thereby causing the single-crystal cathode material to show good rate performance and low DCR. Meanwhile, the generation of the microcracks in the single-crystal cathode material might also be inhibited by reducing lattice strain, thereby improving the cycling performance of the single-crystal cathode material.

According to data in Table 1 and Table 2, the distribution uniformity of the Ni, Co, and Mn elements in the cathode material precursor and the distribution uniformity of the Ni, Co, and Mn elements in the single-crystal cathode material had a good inheritance. If the range and standard deviation of the mass content of each element of Ni, Co, and Mn in the cathode material precursor were smaller, the range and standard deviation of the mass content of each element of Ni, Co, and Mn in the single-crystal cathode material were also smaller. In addition, the range and standard deviation of the Ni, Co, and Mn contents in the single-crystal cathode material were always smaller than those in the precursor, this was because the single-crystal cathode material was required to be sintered at a high temperature during preparation, metal ions were further diffused, thereby improving the distribution uniformity of the Ni, Co, and Mn elements.

According to test data in Tables 1-3, it might be learned that, the comprehensive performance of the single-crystal cathode material prepared in Embodiment 1 was the best.

By comparing Embodiment 1 with Embodiment 2, the single-crystal cathode material in Embodiment 1 showed high rate performance, low impedance, and high cycling performance, this was because, when the cathode material precursor was prepared in Embodiment 1, the atomize mixed solution undergoing thermal decomposition was at an appropriate temperature, such that the surface area weighted average particle size D[3, 2] of the cathode material precursor was low, the reaction activity of the cathode material precursor was high, defects of a crystal structure of the single-crystal cathode material were reduced, and the lattice strain of the single-crystal cathode material was low. Therefore, the single-crystal cathode material prepared in Embodiment 1 showed better rate performance, lower impedance, and better cycling performance.

Compared with Embodiment 1, in the process of sintering the cathode material precursor and the lithium source in Embodiment 5, the sintering temperature increased, the range and standard deviation of the mass content of each element of Ni, Co, and Mn in the single-crystal cathode material were lower, and the lattice strain $\varepsilon$ of the single-crystal cathode material reduced, such that the cycling performance was improved. However, since the grain size of the single-crystal cathode material was significantly larger, and a Li ion diffusion path became longer, the rate performance of the single-crystal cathode material prepared in Embodiment 5 was reduced compared to Embodiment 1.

Compared with Embodiment 1, in the process of sintering the cathode material precursor and the lithium source in Embodiment 6, the sintering temperature reduced, causing the grain size of the single-crystal cathode material to be smaller; and the lattice strain $\varepsilon$ increased, such that the cycling stability of the single-crystal cathode material in Embodiment 6 was reduced compared with the single-crystal cathode material in Embodiment 1.

Compared with Embodiment 1, the content of free $SO_4^{2-}$ of the precursor and cathode material in Embodiment 9 reduced, and better rate and cycling performance were shown.

Compared with Embodiment 1, for the single-crystal cathode material precursor in Embodiment 10, ultrasonic stirring was not performed before the mixed solution was atomized, and the range and standard deviation of the mass content of each element of Ni, Co, and Mn in the monocrystalline cathode precursor were higher, affecting cycling and internal resistance thereof.

Compared with Embodiment 1, for the single-crystal cathode material precursor in Embodiment 11, the polyethylene glycol was not added and ultrasonic stirring was not performed before the mixed solution was atomized, the surface area weighted average particle size D[3, 2] of the single-crystal cathode material was larger, large particles agglomerated might appear, and the range and standard deviation of the mass content of each element of Ni, Co, and Mn in the monocrystalline cathode precursor were higher, affecting cycling and internal resistance thereof.

Compared with Embodiment 1, the free $SO_4^{2-}$ of the cathode material in Comparative example 6 exceeded 1000 ppm. Excessive $SO_4^{2-}$ caused the capacity, rate and cycling performance of the material to deteriorate.

Compared with Embodiment 1, the temperature for thermal decomposition of the cathode material precursor in Comparative example 1 was increased during preparation, such that the surface area weighted average particle size D[3, 2] of the cathode material precursor was greater than 2.0 $\mu$m. The reaction activity of the cathode material precursor was poor, causing more defects in the subsequently prepared single-crystal cathode material, and the lattice strain $\varepsilon$ exceeded 0.2%, causing the single-crystal cathode material to show poor rate performance, high DCR, and low cycling performance.

Compared with Embodiment 1, in the process of preparing the cathode material precursor in Comparative example 2, an atomization flow rate increased, the standard deviation and range of the mass content of each element of Ni, Co, and Mn in the prepared cathode material precursor significantly increased, causing the distribution uniformity of the Ni, Co, and Mn elements in the prepared single-crystal cathode material to reduce, the lattice strain increased, and the lattice strain $\varepsilon$ exceeded 0.2%, such that the rate performance and cycling performance of the single-crystal cathode material prepared in Comparative example 2 were both reduced.

Compared with Embodiment 1, in the process of sintering the cathode material precursor and the lithium source in Comparative example 3, the sintering temperature was too low, and the obtained cathode material was of a polycrystalline structure. The grain size of the cathode material was lower than 150 nm, and thus had good rate performance. However, the lattice strain exceeded 0.2%, and cracking and powdering were prone to appear during cycling, reducing the structural stability of the cathode material, and thus causing great fading in the cycling capacity of the cathode material.

Compared with Embodiment 1, the standard deviation and range of the mass content of each element of Ni, Co, and Mn in the prepared cathode material precursor in Comparative example 4 were significantly greater than those in Embodiment 1, and the lattice strain of the prepared single-crystal cathode material significantly increased, which exceeded 0.2%, such that the rate performance and cycling performance of the single-crystal cathode material were significantly reduced.

Likewise, for the single-crystal cathode material prepared in Comparative example 5, the surface area weighted average particle size D[3, 2] of the cathode material precursor was too large, and the standard deviation and range of the mass content of each element of Ni, Co, and Mn in the cathode material precursor were significantly greater than those in Embodiment 1, such that the lattice strain of the prepared single-crystal cathode material significantly increased, which exceeded 0.2%, leading to significant reduction in the rate performance and cycling performance of the cathode material.

The above were only preferred embodiments of the present application, and were not used to limit the present application. Any modifications, equivalent replacements and improvements and the like made within the spirit and principle of the present application should be included within the scope of protection of the present application.

## Claims

**1.** A single-crystal cathode material, wherein a general chemical formula of the single-crystal cathode material is

$Li_xNi_aCo_bMn_cN_dO_2$, wherein $0.98 \leq x \leq 1.1$, $0.50 \leq a \leq 0.98$, $0 < b \leq 0.20$, $0 < c \leq 0.30$, $0 \leq d \leq 0.10$, $a+b+c+d=1$, and N comprises at least one of Al, Ti, Zr, Mg, Sr, Ba, Ca, Nb, W, Sb, Ta, Sn, or Y;

When the single crystal cathode materials are observed by Scanning Electron Microscope (SEM) at a magnification of 3K, 10 points are randomly selected to perform an Energy Dispersive Spectrometer (EDS) point scanning to test contents of Ni, Co, and Mn, and in EDS spectrum results of the single-crystal cathode material, a standard deviation of a mass content of each element of Ni, Co, and Mn in the single-crystal cathode material is $\leq 0.03$; and lattice strain of the single-crystal cathode material is $\varepsilon$, and $\varepsilon < 0.2\%$.

2. The single-crystal cathode material according to claim 1, comprising $SO_4^{2-}$, wherein a content of the $SO_4^{2-}$ is $\delta$, and 0 ppm $\leq \delta \leq 800$ ppm.

3. The single-crystal cathode material according to claim 1, containing at least one single crystal grain with a same orientation, wherein an average particle size of the single crystal grains is 1 $\mu$m-5 $\mu$m.

4. The single-crystal cathode material according to claim 1, wherein a range of the mass content of each element of the Ni, Co, and Mn in the single-crystal cathode material is $\leq 0.08$.

5. The single-crystal cathode material according to claim 1, further comprising a coating layer, wherein the coating layer comprises a metal oxide or a lithium ion conductor; and a metal in the metal oxide comprises at least one of Al, Ti, Zr, Y, Nb, Mg, W, B, Ce, Co, or Mn.

6. The single-crystal cathode material according to any one of claims 1 to 5, meeting at least one of the following features:

   (1) a grain size of the single-crystal cathode material is D, and 150 nm < D < 250 nm;
   (2) an average particle size $D_{50}$ of the single-crystal cathode material is 1.5 $\mu$m-5 $\mu$m; and
   (3) a tap density of the single-crystal cathode material is >1.5 $g/cm^3$.

7. The single-crystal cathode material according to claim 6, meeting at least one of the following features:

   (1) the average particle size $D_{50}$ of the single-crystal cathode material is 3.0-4.5 $\mu$m;
   (2) a compaction density of the single-crystal cathode material is 1.68-2.2 $g/cm^3$; and
   (3) the general chemical formula of the single-crystal cathode material comprises at least one of $LiNi_{0.67}Co_{0.05}Mn_{0.28}O_2$, $LiNi_{0.88}Co_{0.06}Mn_{0.04}O_2$, or $LiNi_{0.88}Co_{0.06}Mn_{0.03}Al_{0.03}O_2$.

8. A cathode material precursor, wherein a general chemical formula of the cathode material precursor is $Ni_aCo_bMn_cN_dO_e$, wherein $0.50 \leq a \leq 0.98$, $0 < b \leq 0.20$, $0 < c \leq 0.30$, $0 \leq d \leq 0.10$, $a+b+c+d=1$, $1 \leq e \leq 1.15$, and N comprises at least one of Al, Ti, Zr, Mg, Sr, Ba, Ca, Nb, W, Sb, Ta, Sn, or Y; and a surface area weighted average particle size of the cathode material precursor is D[3, 2] < 2.0 $\mu$m, and a standard deviation of a mass content of each element of Ni, Co, and Mn in the cathode material precursor is $\leq 0.05$.

9. The cathode material precursor according to claim 8, comprising $SO_4^{2-}$, wherein a content of the $SO_4^{2-}$ is $\eta$, and 0 ppm $\leq \eta \leq 1800$ ppm.

10. The cathode material precursor according to claim 8, wherein a range of the mass content of each element of the Ni, Co, and Mn in the cathode material precursor is $\leq 0.12$.

11. The cathode material precursor according to claim 8, meeting at least one of the following technical features:

   (1) the cathode material precursor comprises a secondary particle, and the secondary particle comprises a plurality of agglomerated primary particles;
   (2) the cathode material precursor comprises the secondary particle, the secondary particle comprises the plurality of agglomerated primary particles, and the primary particles are spherical in shape; and
   (3) the cathode material precursor comprises the secondary particle, the secondary particle comprises the plurality of agglomerated primary particles, and a particle size of the primary particle is 20 nm-1000 nm.

12. The cathode material precursor according to claim 8, meeting at least one of the following technical features:

(1) an average particle size $D_{50}$ of the cathode material precursor is <3.5 $\mu$m;
(2) a specific surface area of the cathode material precursor is >5 $m^2/g$; and
(3) a tap density of the cathode material precursor is >1 $g/cm^3$.

13. A method for preparing a single-crystal cathode material, comprising the following steps:

performing atomization treatment on a mixed solution containing a nickel salt, a cobalt salt, and a manganese salt, and then performing thermal decomposition to obtain a cathode material precursor, wherein a surface area weighted average particle size of the cathode material precursor is D[3, 2]<2.0 $\mu$m, and a standard deviation of a mass content of each element of Ni, Co, and Mn in the cathode material precursor is ≤0.05; and
mixing the cathode material precursor and a lithium source, and then placing same under an oxygen-containing atmosphere for sintering, so as to obtain a single-crystal cathode material, wherein a standard deviation of a mass content of each element of Ni, Co, and Mn in the single-crystal cathode material is ≤0.03; and lattice strain of the single-crystal cathode material is $\varepsilon$, and $\varepsilon$<0.2%.

14. The preparation method according to claim 13, comprising at least one of the following features:

(1) a molar ratio of Ni, Co, to Mn in the mixed solution is (50-98):(0-20):(0-30), and the contents of the Co and Mn in the mixed solution are both not 0;
(2) a total metal concentration in the mixed solution is 200 g/L-500 g/L;
(3) the mixed solution further comprises a doping agent containing an N element, and N comprises at least one of Al, Ti, Zr, Mg, Sr, Ba, Ca, Nb, W, Sb, Ta, Sn, or Y;
(4) a general chemical formula of the cathode material precursor is $Ni_aCo_bMn_cN_dO_e$, wherein 0.50≤a≤0.98, 0<b≤0.20, 0<c≤0.30, 0≤d≤0.10, a+b+c+d=1, 1≤e≤1.15, and N comprises at least one of Al, Ti, Zr, Mg, Sr, Ba, Ca, Nb, W, Sb, Ta, Sn, or Y;
(5) a flow rate of the mixed solution is 100 L/h-900 L/h;
(6) pressure for atomization treatment is 0.4 MPa-0.8 MPa; and
(7) a temperature for thermal decomposition is 500 °C-850 °C.

15. A lithium ion battery, comprising the single-crystal cathode material according to any one of claims 1 to 12 or a single-crystal cathode material prepared by the method for preparing a single-crystal cathode material according to claim 13 or 14.

Fig. 1

Fig. 2

| Atomic ratio | Ni | Co | Mn |
|---|---|---|---|
| Point 1 | 0.624 | 0.065 | 0.311 |
| Point 2 | 0.703 | 0.045 | 0.252 |
| Point 3 | 0.656 | 0.057 | 0.287 |
| Point 4 | 0.713 | 0.043 | 0.244 |
| Point 5 | 0.682 | 0.036 | 0.282 |
| Point 6 | 0.673 | 0.053 | 0.275 |
| Point 7 | 0.626 | 0.057 | 0.317 |
| Point 8 | 0.618 | 0.058 | 0.325 |
| Point 9 | 0.677 | 0.062 | 0.261 |
| Point 10 | 0.709 | 0.047 | 0.244 |
| Range | **0.095** | **0.029** | **0.081** |
| Standard deviation | **0.036** | **0.009** | **0.030** |

Fig.3

Williamsone-Hall analysis

$y = 0.0011x + 0.0007$

Fig. 4

## INTERNATIONAL SEARCH REPORT

| International application No. |
|---|
| **PCT/CN2024/122465** |

### A. CLASSIFICATION OF SUBJECT MATTER

H01M 4/505(2010.01)i; H01M 4/525(2010.01)i; H01M 10/0525(2010.01)i; C01G 53/00(2006.01)i; C30B 29/22(2006.01)i; C30B 1/10(2006.01)i

According to International Patent Classification (IPC) or to both national classification and IPC

### B. FIELDS SEARCHED

Minimum documentation searched (classification system followed by classification symbols)

IPC:H01M 4/-, H01M 10/-,C01G 53/-,C30B 29/-, C30B 1/-

Documentation searched other than minimum documentation to the extent that such documents are included in the fields searched

Electronic data base consulted during the international search (name of data base and, where practicable, search terms used)

CNTXT, ENTXTC, ENTXT, DWPI, CNKI: 正极, 晶体, 单晶, 标准差, 方差, 均匀性, 晶格应变, anode, single crystal, Li, Ni, Co, Mn, lithium, nickel, cobalt, manganese, standard deviation, lattice strain

### C. DOCUMENTS CONSIDERED TO BE RELEVANT

| Category* | Citation of document, with indication, where appropriate, of the relevant passages | Relevant to claim No. |
|---|---|---|
| X | WO 2021042983 A1 (CONTEMPORARY AMPEREX TECHNOLOGY CO., LTD.) 11 March 2021 (2021-03-11) description, paragraphs 8-94 | 8-12, 15 |
| Y | WO 2021042983 A1 (CONTEMPORARY AMPEREX TECHNOLOGY CO., LTD.) 11 March 2021 (2021-03-11) description, paragraphs 8-94 | 1-7, 13-15 |
| Y | JP 2010219065 A (NGK INSULATORS LTD.) 30 September 2010 (2010-09-30) description, paragraph 36 | 1-7, 13-15 |
| Y | CN 115626668 A (HUNAN LIHE HOUPU TECHNOLOGY CO., LTD.) 20 January 2023 (2023-01-20) description, paragraphs 3-21 | 13-15 |
| PX | CN 117457890 A (SHENZHEN CITY BATTERY NANOMETER TECHNOLOGY CO., LTD.) 26 January 2024 (2024-01-26) claims 1-10 | 1-15 |

☑ Further documents are listed in the continuation of Box C.　　☑ See patent family annex.

| | |
|---|---|
| * Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **17 December 2024** | **23 December 2024** |

| Name and mailing address of the ISA/CN | Authorized officer |
|---|---|
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

**EP 4 576 259 A1**

**INTERNATIONAL SEARCH REPORT**

| International application No. |
| --- |
| **PCT/CN2024/122465** |

**C.    DOCUMENTS CONSIDERED TO BE RELEVANT**

| Category* | Citation of document, with indication, where appropriate, of the relevant passages | Relevant to claim No. |
| --- | --- | --- |
| A | WO 2023013543 A1 (SUPER NANO DESIGN CO., LTD.) 09 February 2023 (2023-02-09) entire description | 1-15 |

INTERNATIONAL SEARCH REPORT
Information on patent family members

International application No.

**PCT/CN2024/122465**

| Patent document cited in search report | | | Publication date (day/month/year) | Patent family member(s) | | | Publication date (day/month/year) |
|---|---|---|---|---|---|---|---|
| WO | 2021042983 | A1 | 11 March 2021 | US | 2022123302 | A1 | 21 April 2022 |
| | | | | US | 11417883 | B2 | 16 August 2022 |
| | | | | EP | 3920283 | A1 | 08 December 2021 |
| | | | | EP | 3920283 | A4 | 08 June 2022 |
| JP | 2010219065 | A | 30 September 2010 | None | | | |
| CN | 115626668 | A | 20 January 2023 | None | | | |
| CN | 117457890 | A | 26 January 2024 | None | | | |
| WO | 2023013543 | A1 | 09 February 2023 | JP | 2023022754 | A | 15 February 2023 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202311331910
- CN 113488642 A
- CN 116230922 A